(19) Europäisches Patentamt
European Patent Office
Office européen des brevets

(11) EP 2 581 954 A1

# (12) EUROPEAN PATENT APPLICATION

published in accordance with Art. 153(4) EPC

(43) Date of publication:
**17.04.2013 Bulletin 2013/16**

(21) Application number: **11792439.9**

(22) Date of filing: **07.06.2011**

(51) Int Cl.:
***H01L 33/48*** *(2010.01)* ***C08K 3/26*** *(2006.01)*
***C08L 83/05*** *(2006.01)* ***C08L 83/07*** *(2006.01)*
***H01L 21/52*** *(2006.01)*

(86) International application number:
**PCT/JP2011/063023**

(87) International publication number:
**WO 2011/155482 (15.12.2011 Gazette 2011/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.06.2010 JP 2010131061**

(71) Applicant: **Sekisui Chemical Co., Ltd.**
**Osaka 530-8565 (JP)**

(72) Inventors:
- **NISHIMURA, Takashi**
  **Mishima-gun**
  **Osaka 618-8589 (JP)**
- **WATANABE, Takashi**
  **Mishima-gun**
  **Osaka 618-8589 (JP)**

(74) Representative: **Merkle, Gebhard**
**ter Meer Steinmeister & Partner GbR**
**Mauerkircherstrasse 45**
**81679 München (DE)**

## (54) DIE-BONDING MATERIAL FOR OPTICAL SEMICONDUCTOR DEVICES AND OPTICAL SEMICONDUCTOR DEVICE USING SAME

(57) The present invention provides a die bonding material for an optical semiconductor device which has high thermal conductivity and can prevent cracking in an optical semiconductor device including the die bonding material.

The die bonding material for an optical semiconductor device includes: a first silicone resin containing a hydrogen atom bonded to a silicon atom, a second silicone resin not containing a hydrogen atom bonded to a silicon atom, but containing an alkenyl group, a catalyst for hydrosilylation reaction, and at least one substance selected from the group consisting of anhydrous magnesium carbonate represented by chemical formula $MgCO_3$ not containing crystal water and coated bodies including the anhydrous magnesium carbonate and an organic resin, a silicone resin, or silica coated on the surface thereof.

[FIG. 1]

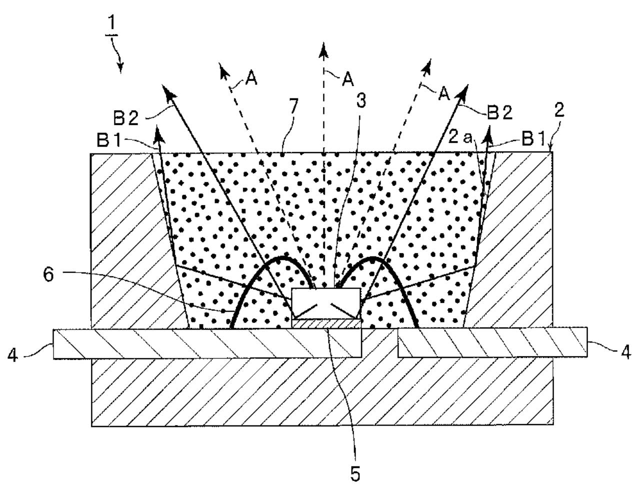




Printed by Jouve, 75001 PARIS (FR)

## Description

### TECHNICAL FIELD

The present invention relates to a die bonding material for an optical semiconductor device that is used for die-bonding an optical semiconductor element such as a light-emitting diode (LED) element. The present invention also relates to an optical semiconductor device in which the die bonding material for an optical semiconductor device is used.

### BACKGROUND ART

Optical semiconductor elements such as light-emitting diode (LED) elements are widely used as a light source of display devices and the like. Optical semiconductor devices using optical semiconductor elements consume low power and have a long life. Moreover optical semiconductor devices can be used under harsh environments. For these reasons, optical semiconductor devices are used in a wide range of applications such as mobile phone backlight, liquid-crystal TV backlight, automobile lamps, lighting apparatuses, and signs.

Patent Document 1 shown below discloses an optical semiconductor device in which an LED element is mounted on a substrate. In the optical semiconductor device, the LED element is attached to an upper surface of the substrate with a die bonding material. The die bonding material contains an alkenyl group-containing organopolysiloxane, an organohydrogenpolysiloxane containing not less than three hydrogen atoms bonded to silicon atoms, a platinum catalyst, and a tackifier. The alkenyl group-containing organopolysiloxane includes 50 to 3000 ppm of hydroxyl group bonded silicone atom, includes on average not less than one alkenyl group bonded silicone atom, and includes an organopolysiloxane having a $SiO_{4/2}$ unit.

Patent Document 1: JP 2009-114365 A

### SUMMARY OF THE INVENTION

### PROBLEMS TO BE SOLVED BY THE INVENTION

The aforementioned optical semiconductor device generates a large amount of heat when the optical semiconductor element emits light. As a result, the optical semiconductor element attached by the die bonding material may be degraded by heat. Suppression of the thermal degradation of the optical semiconductor element requires sufficient diffusion of the generated heat through the die bonding material.

However, conventional die bonding materials as that disclosed in Patent Document 1, cannot sufficiently diffuse heat.

In general, alumina and zinc oxide as a filler have a high thermal conductivity, and are thus known as materials excellent in heat dissipation. However, alumina and zinc oxide have a relatively high specific gravity. Therefore, if alumina and zinc oxide are added to a die bonding material, the alumina and the zinc oxide problematically deposit in the die bonding material.

Furthermore, conventional die bonding materials for an optical semiconductor device including the above filler problematically tend to crack in the optical semiconductor devices including the die bonding material.

The present invention aims to provide a die bonding material for an optical semiconductor device having high thermal conductivity and capable of preventing cracking in an optical semiconductor device including the die bonding material. The present invention further aims to provide an optical semiconductor device in which the die bonding material for an optical semiconductor device is used.

### MEANS FOR SOLVING THE PROBLEMS

A broad aspect of the present invention provides a die bonding material for an optical semiconductor device, including a first silicone resin containing a hydrogen atom bonded to a silicon atom, a second silicone resin not containing a hydrogen atom bonded to a silicon atom but containing an alkenyl group, a catalyst for hydrosilylation reaction, and at least one substance selected from the group consisting of anhydrous magnesium carbonate represented by chemical formula $MgCO_3$ not containing crystal water and coated bodies including the anhydrous magnesium carbonate and an organic resin, a silicone resin, or silica coated on the surface thereof.

In a specific aspect of the die bonding material for an optical semiconductor device according to the present invention, the first silicone resin is a first silicone resin which is represented by formula (1A) or formula (1B) shown below, and contains a hydrogen atom bonded to a silicon atom, and the second silicone resin is a second silicone resin which is represented by formula (51A) or formula (51B) shown below, does not contain a hydrogen atom bonded to a silicon atom, but contains an alkenyl group.

**[Chem. 1] $(R1R2R3SiO_{1/2})_a(R4R5SiO_{2/2})_b(R6SiO_{3/2})_c$ ... Formula (1A)**

In the formula (1A), a, b, and c satisfy the following equations: a/(a+b+c) = 0.05 to 0.50, b/(a+b+c) = 0 to 0.40, and c/(a+b+c) = 0.30 to 0.80; and at least one of R1 to R6 represents a hydrogen atom, and the rest of the R1 to R6 other than hydrogen atoms represent $C_1$ to $C_8$ hydrocarbon groups;

**[Chem. 2] $(R1\ R2R3SiO_{1/2})a(R4R5SiO_{2/2})_b(R6SiO_{3/2})_c(R7R8R9R10Si_2R11O_{2/2})_d$ Formula (1B)**

In the formula (1B), a, b, c and d satisfy the following equations: a/(a+b+c+d) = 0.05 to 0.50, b/(a+b+c+d) = 0 to 0.40, c/(a+b+c+d) = 0.30 to 0.80, and d/(a+b+c+d) = 0.01 to 0.40; and at least one of R1 to R6 represents a hydrogen atom, the rest of the R1 to R6 other than hydrogen atoms represent $C_1$ to $C_8$ hydrocarbon groups, R7 to R10 each represent $C_1$ to $C_8$ hydrocarbon groups, and R11 represents a $C_1$ to $C_8$ bivalent hydrocarbon group;

**[Chem. 3] $(R51R52R53SiO_{1/2})_p(R54R55SiO_{2/2})_q(R56SiO_{3/2})_r$ Formula (51A)**

In the formula (51A), p, q, and r satisfy the following equations: p/(p+q+r) = 0.05 to 0.50, q/(p+q+r) = 0 to 0.40, and r/(p+q+r) = 0.30 to 0.80; and at least one of R51 to R56 represents a phenyl group, at least one of R51 to R56 represents an alkenyl group, and the rest of the R51 to R56 other than phenyl groups and alkenyl groups represent $C_1$ to $C_8$ hydrocarbon groups;

**[Chem. 4] $(R51R52R53SiO_{1/2})_p(R54R55SiO_{2/2})_q(R56SiO_{3/2})_r(R57R58R59R6OSi_2R610_{2/2})s$ Formula (51B)**

In the formula (51B), p, q, r and s satisfy the following equations: p/(p+q+r+s) = 0.05 to 0.50, q/(p+q+r+s) = 0 to 0.40, r/(p+q+r+s) = 0.30 to 0.80, and s/(p+q+r+s) = 0.01 to 0.40; and at least one of R51 to R56 represents a phenyl group, at least one of R51 to R56 represents an alkenyl group, the rest of the R51 to R56 other than phenyl groups and alkenyl groups represent $C_1$ to $C_8$ hydrocarbon groups, R57 to R60 each represent a $C_1$ to $C_8$ hydrocarbon group, and R61 represents a $C_1$ to $C_8$ bivalent hydrocarbon group.

In another specific aspect of the die bonding material for an optical semiconductor device according to the present invention, the first silicone resin is a first silicone resin containing a hydrogen atom bonded to a silicon atom and an alkenyl group.

In another specific aspect of the die bonding material for an optical semiconductor device according to the present invention, the substance has an average particle diameter of not more than 3 $\mu$m.

In yet another specific aspect of the die bonding material for an optical semiconductor device according to the present invention, the die bonding material further includes a filler which is different from the substance and has an average particle diameter of 0.01 $\mu$m to 2 $\mu$m and a thermal conductivity of not less than 10 W/m·K.

In other specific aspects of the die bonding material for an optical semiconductor device according to the present invention, the filler is at least one selected from the group consisting of aluminum oxide, boron nitride, silicon nitride, and zinc oxide.

The optical semiconductor device of the present invention is provided with the die bonding material for an optical semiconductor device configured according to the present invention, a member to be connected, and an optical semiconductor element connected to the member to be connected with the die bonding material for an optical semiconductor device.

## EFFECT OF THE INVENTION

The die bonding material for an optical semiconductor device according to the present invention includes a first silicone resin containing a hydrogen atom bonded to a silicon atom, a second silicone resin not containing a hydrogen atom bonded to a silicon atom, but containing an alkenyl group, a catalyst for hydrosilylation reaction, and at least one substance selected from the group consisting of anhydrous magnesium carbonate represented by chemical formula $MgCO_3$ not containing crystal water and coated bodies including the anhydrous magnesium carbonate and an organic resin, a silicone resin, or silica coated on the surface thereof. Therefore, the die bonding material of the present invention can have high thermal conductivity. Moreover, the die bonding material can be prevented from cracking in the optical semiconductor device including the die bonding material.

## BRIEF DESCRIPTION OF DRAWINGS

Fig. 1 is a front cross-sectional view showing an optical semiconductor device according to one embodiment of the present invention.

## MODES FOR CARRYING OUT THE INVENTION

The following description will discuss details of the present invention.

The die bonding material for an optical semiconductor device according to the present invention includes a first silicone resin containing a hydrogen atom bonded to a silicon atom, a second silicone resin not containing a hydrogen atom bonded to a silicon atom, but containing an alkenyl group, a catalyst for hydrosilylation reaction, and a substance (X). The substance (X) is at least one of anhydrous magnesium carbonate (X1) represented by chemical formula $MgCO_3$ not containing crystal water and coated bodies (X2) including the anhydrous magnesium carbonate and an organic resin, a silicone resin, or silica coated on the surface thereof.

If a die bonding material has the aforementioned composition, thermal conductivity of the die bonding material can be increased. Moreover, in addition to the increase in the thermal conductivity of the die bonding material, the die bonding material can be prevented from cracking in the optical semiconductor device including die bonding material. High thermal conductivity of the die bonding material leads to sufficient diffusion of heat generated from the optical semiconductor element, and thus thermal degradation of the optical semiconductor element can be suppressed. As a result, the optical semiconductor device can have a long service lifetime, and has a higher reliability.

In general, zinc oxide, aluminum nitride, boron nitride, alumina, magnesium oxide, silica, and the like are used as a filler for providing thermal conductivity. Nitrides have extremely high thermal conductivity. For example, the thermal conductivity of aluminum nitride is 150 W/m·K to 250 W/m·K, and the thermal conductivity of boron nitride is 30 W/m·K to 50 W/m·K. However, nitrides are very expensive. Alumina is relatively inexpensive, and has relatively high thermal conductivity of 20 W/m·K to 35 W/m·K. However, alumina has high hardness with a Mohs hardness of 9. For this reason, in the case where alumina is used, a problem of cracking in the die bonding material may supposedly arise. Magnesium oxide is inexpensive, and the thermal conductivity is good with 45 W/m·K to 60 W/m·K. However, magnesium oxide has low water resistance. Silica is extremely inexpensive. However, silica has low thermal conductivity of 2 W/m·K. Moreover, since alumina and zinc oxide have relatively a high specific gravity, alumina and zinc oxide problematically deposit in the die bonding material.

The anhydrous magnesium carbonate (X1) represented by chemical formula $MgCO_3$ not containing crystal water has a relatively good thermal conductivity of 15 W/m·K and low Mohs hardness of 3.5. Therefore, use of the anhydrous magnesium carbonate (X1) or the coated body (X2) containing the anhydrous magnesium carbonate can increase the thermal conductivity of the die bonding material, and can prevent the die bonding material from cracking. Moreover, the anhydrous magnesium carbonate (X1) is less expensive than nitrides. Therefore, use of the anhydrous magnesium carbonate (X1) or the coated body (X2) containing the anhydrous magnesium carbonate can reduce the production cost of the die boning material for an optical semiconductor device.

The anhydrous magnesium carbonate (X1) represented by chemical formula $MgCO_3$ not containing crystal water is different, for example, from magnesium hydroxide carbonate represented by chemical formula $4MqCO_3 \cdot Mg(OH_2) \cdot H_2O$. This magnesium hydroxide carbonate is also simply referred to as magnesium carbonate. When this magnesium hydroxide carbonate is heated to about 100°C, crystal water is released. Therefore, this magnesium hydroxide carbonate is not appropriate for use in optical semiconductor devices which are required to have such properties as high heat resistance.

The aryl group content in each of the first silicone resin and the second silicone resin calculated based on formula (X) shown below is preferably not less than 10 mol%, more preferably not less than 20 mol%, and preferably not more than 50 mol%, more preferably not more than 40 mol%. The aryl group content of not less than the aforementioned minimum value and not more than the aforementioned maximum value further enhances the gas barrier property, and prevents the die bonding material from peeling off.

(Formula X)

[Aryl group content (mol%)] = [(Average number of aryl group included in one molecule of the first silicone resin or the second silicone resin × Molecular weight of the aryl group)/(Number average molecular weight of the first silicone resin or the second silicone resin)] × 100

(First silicone resin)

The first silicone resin contained in the die bonding material for an optical semiconductor device according to the present invention includes a hydrogen atom bonded to a silicon atom. The hydrogen atom is directly bonded to a silicon atom. In terms of further enhancing the gas barrier property of the die bonding material, the first silicone resin preferably includes a hydrogen atom bonded to a silicon atom and an aryl group. Examples of the aryl group include unsubstituted phenyl groups, substituted phenyl groups, unsubstituted phenylene groups, and substituted phenylene groups.

In terms of achieving a die bonding material with further enhanced gas barrier property, the first silicone resin preferably includes a hydrogen atom bonded to a silicon atom and an alkenyl group.

In terms of achieving a die bonding material with further enhanced gas barrier property, the first silicone resin is preferably a first silicone resin represented by formula (1A) or formula (1B) shown below. It is noted that, a first silicone resin other than the first silicone resin represented by the formula (1A) or the formula (1B) shown below may also be used as the first silicone resin. The first silicone resin represented by the formula (1B) shown below may contain a phenylene group or may not contain a phenylene group. The first silicone resin may be used solely, or two or more kinds thereof may be used in combination.

**[Chem. 5]** $(R1R2R3SiO_{1/2})_a(R4R5SiO_{2/2})_b(R6SiO_{3/2})_c$ Formula (1A)

In the formula (1A), a, b, and c satisfy the following equations: a/(a+b+c) = 0.05 to 0.50, b/(a+b+c) = 0 to 0.40, and c/(a+b+c) = 0.30 to 0.80; and at least one of R1 to R6 represents a hydrogen atom, and the rest of the R1 to R6 other than hydrogen atoms represent $C_1$ to $C_8$ hydrocarbon groups. In the formula (1A), a unit represented by $(R4R5SiO_{2/2})$ and a unit represented by $(R6SiO_{3/2})$ each may include an alkoxy group or may include a hydroxy group.

**[Chem. 6]** $(R1R2R3SiO_{1/2})_a(R4R5SiO_{2/2})_b (R6SiO_{3/2})_c(R7R8R9R1OSi_2R11O_{2/2})_d$ **Formula (1B)**

In the formula (1B), a, b, c and d satisfy the following equations: a/(a+b+c+d) = 0.05 to 0.50, b/(a+b+c+d) = 0 to 0.40, c/(a+b+c+d) = 0.30 to 0.80, and d/(a+b+c+d) = 0.01 to 0.40; and at least one of R1 to R6 represents a hydrogen atom, the rest of the R1 to R6 other than hydrogen atoms represent $C_1$ to $C_8$ hydrocarbon groups, R7 to R10 each represent a $C_1$ to $C_8$ hydrocarbon group, and R11 represents a $C_1$ to $C_8$ bivalent hydrocarbon group. In the formula (1B), a unit represented by $(R4R5SiO_{2/2})$, a unit represented by $(R6SiO_{3/2})$, and a unit represented by $(R7R8R9R10Si_2R110_{2/2})$ each may include an alkoxy group or may include a hydroxy group.

In terms of achieving a die bonding material with far more enhanced gas barrier property, preferably, at least one of R1 to R6 represents a phenyl group, at least one of R1 to R6 represents a hydrogen atom, and the rest of R1 to R6 other than phenyl groups and hydrogen atoms represent $C_1$ to $C_8$ hydrocarbon groups in the formula (1A).

In terms of achieving a die bonding material with far more enhanced gas barrier property, preferably, at least one of R1 to R6 represents a phenyl group, at least one of R1 to R6 represents a hydrogen atom, and the rest of R1 to R6 other than phenyl groups and hydrogen atoms represent $C_1$ to $C_8$ hydrocarbon groups in the formula (1B).

In terms of achieving a die bonding material with far more enhanced gas barrier property, preferably, at least one of R1 to R6 represents a hydrogen atom, at least one of R1 to R6 represents an alkenyl group, and the rest of R1 to R6 other than hydrogen atoms and alkenyl groups represent $C_1$ to $C_8$ hydrocarbon groups in the formula (1A).

In terms of achieving a die bonding material with far more enhanced gas barrier property, preferably, at least one of R1 to R6 represents a hydrogen atom, at least one of R1 to R6 represents an alkenyl group, and the rest of R1 to R6 other than hydrogen atoms and alkenyl groups represent $C_1$ to $C_8$ hydrocarbon groups in the formula (1B).

In terms of achieving a die bonding material with far more enhanced gas barrier property, preferably, at least one of R1 to R6 represents a phenyl group, at least one of R1 to R6 represents a hydrogen atom, at least one of R1 to R6 represents an alkenyl group, and the rest of R1 to R6 other than phenyl groups, hydrogen atoms, and alkenyl groups represent $C_1$ to $C_8$ hydrocarbon groups in the formula (1A).

In terms of achieving a die bonding material with far more enhanced gas barrier property, preferably, at least one of R1 to R6 represents a phenyl group, at least one of R1 to R6 represents a hydrogen atom, at least one of R1 to R6 represents an alkenyl group, and the rest of R1 to R6 other than phenyl groups, hydrogen atoms, and alkenyl groups represent $C_1$ to $C_8$ hydrocarbon groups in the formula (1B).

The formula (1A) and the formula (1B) each are an average composition formula. Hydrocarbon groups in the formula (1A) and the formula (1B) may be linear or branched chains. R1 to R6 in the formula (1A) and the formula (1B) may be the same or different from one another. R7 to R10 in the formula (B) may be the same or different from one another. R7 to R10 in the formula (1B) may be the same or different from one another.

The oxygen atom part in the unit represented by ($R4R5SiO_{2/2}$), the oxygen atom part in the unit represented by ($R6SiO_{3/2}$), and the oxygen atom part in the unit represented by ($R7R8R9R10Si_2R11O_{2/2}$) in the formula (1A) and the formula (1B) each are an oxygen atom part forming a siloxane bond, an oxygen atom part in the alkoxy group, or an oxygen atom part in the hydroxy group.

Generally, in the respective units of the formula (1A) and the formula (1B), an alkoxy group content is small, and also a hydroxy group content is small as well. This is because, when an organic silicon compound such as an alkoxy silane compound is hydrolyzed and polymerized to provide the first silicone resin, most of the alkoxy groups and the hydroxy groups are normally converted to form a partial structure of a siloxane bond. Namely, the oxygen atom in the alkoxy group and the oxygen atom in the hydroxy group are mostly converted to the oxygen atoms forming the siloxane bond. Presence of an alkoxy group or a hydroxy group in each of the units of the formula (1A) and the formula (1B) indicates that unreacted alkoxy group or hydroxy group not converted to the partial structure of the siloxane bond remains in a small amount. The same is true to the case where respective units of below-mentioned formula (51A) and formula (51B) include an alkoxy group and a hydroxy group.

The $C_1$ to $C_8$ hydrocarbon group in the formula (1A) and the formula (1B) is not particularly limited, and examples thereof include a methyl group, an ethyl group, an n-propyl group, an n-butyl group, an n-pentyl group, an n-hexyl group, an n-heptyl group, an n-octyl group, an isopropyl group, an isobutyl group, a sec-butyl group, a t-butyl group, an isopentyl group, a neopentyl group, a t-pentyl group, an isohexyl group, a cyclohexyl group, a vinyl group, an allyl group, and a phenyl group.

The $C_1$ to $C_8$ bivalent hydrocarbon group in the formula (1B) is not particularly limited, and examples thereof include a methylene group, an ethylene group, a propylene group, a butylene group, a pentylene group, a hexylene group, a cyclohexylene group, and a phenylene group.

Examples of the alkenyl group in the formula (1A) and the formula (1B) include a vinyl group, an allyl group, a butenyl group, a pentenyl group, and a hexenyl group. In terms of further enhancing the gas barrier property, the alkenyl group in the first silicone resin is preferably a vinyl group or an allyl group, and more preferably a vinyl group.

The aryl group content in the first silicone resin represented by the formula (1A) or the formula (1B) calculated based on formula (X1) shown below is preferably not less than 10 mol%, and is preferably not more than 50 mol%. The aryl group content of not less than 10 mol% further enhances the gas barrier property. The aryl group content of not more than 50 mol% tends to prevent the die bonding material from peeling off. In terms of far more enhancing the gas barrier property, the aryl group content is more preferably not less than 20 mol%. In terms of further preventing peeling of the die bonding material, the aryl group content is more preferably not more than 40 mol%.

(Formula X1)

[Aryl group content (mol%)] = [(Average number of aryl group included in one molecule of the first silicone resin whose average composition is represented by the formula (1A) or the formula (1B) × Molecular weight of the aryl group)/(Number average molecular weight of the first silicone resin whose average composition is represented by the formula (1A) or the formula (1B))] × 100

In the case of using the first silicone resin represented by the formula (1A) and containing a phenyl group, the aryl group in the formula (X1) represents a phenyl group.
The aryl group content shows the phenyl group content.

In the case of using the first silicone resin represented by the formula (1B) and containing a phenyl group and a phenylene group, the aryl group in the formula (X1) represents a phenyl group and a phenylene group. The aryl group content shows a total content of the phenyl group and the phenylene group.

In the case of using the first silicone resin represented by the formula (1B) and containing a phenyl group but not containing a phenylene group, the aryl group in the formula (X1) represents a phenyl group. The aryl group content shows the phenyl group content.

In terms of further enhancing the gas barrier property, the unit ($R7R8R9R10Si_2R11O_{2/2}$) in the formula (1B) is preferably a unit represented by formula (1b-1) shown below. The unit represented by the formula (1b-1) includes a phenylene group, and the phenylene group is a substituted or unsubstituted phenylene group. The term "phenylene group" used herein also includes a substituted phenylene group in which the $C_1$ to $C_8$ hydrocarbon group is replaced by a benzene ring.

**[Chem. 7]**

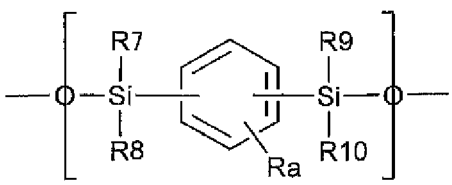

···Formula (1b-1)

In the formula (1b-1), Ra represents a hydrogen atom or a $C_1$ to $C_8$ hydrocarbon group, and R7 to R10 each represent a $C_1$ to $C_8$ hydrocarbon group. The hydrocarbon group may be a linear or branched chain. Binding sites of the three groups to the benzene ring in the formula (1b-1) are not particularly limited. In the unit represented by the formula (1b-1) , generally, an oxygen atom at the terminal position and an adjacent silicon atom form a siloxane bond, and the oxygen atom is shared with the adjacent unit. Therefore, one of the terminal oxygen atoms is expressed as "$O_{1/2}$."

The unit ($R7R8R9R10Si_2R11O_{2/2}$) in the formula (1B) is preferably a unit represented by formula (1b-2) shown below. The unit represented by the formula (1b-2) includes a phenylene group, and the phenylene group is a substituted or unsubstituted phenylene group. A binding site of the Ra to the benzene ring in the formula (1b-2) is not particularly limited.

[Chem. 8]

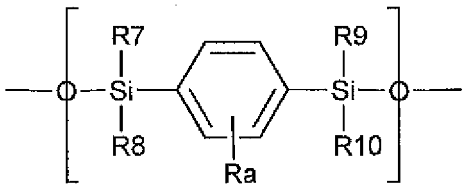

· · ·Formula (1b-2)

In the formula (1b-2) Ra represents a hydrogen atom or a $C_1$ to $C_8$ hydrocarbon group, and R7 to R10 each represent a $C_1$ to $C_8$ hydrocarbon group.

The unit ($R7R8R9R10Si_2R110_{2/2}$) in the formula (1B) is more preferably a unit represented by formula (1b-3) shown below. The unit represented by the formula (1b-3) includes a phenylene group, and the phenylene group is an unsubstituted phenylene group.

[Chem. 9]

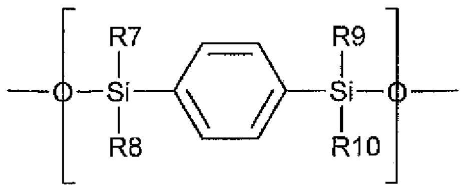

· · ·Formula (1b-3)

In the formula (1b-3), R7 to R10 each represent a $C_1$ to $C_8$ hydrocarbon group.

In the first silicone resin represented by the formula (1A) or the formula (1B), the unit represented by ($R4R5SiO_{2/2}$) (hereinafter, also referred to as a bi-functional unit) may include a unit represented by formula (1-2) shown below, i.e., a structure in which one of oxygen atoms bonded to a silicon atom in the bi-functional unit constitutes a hydroxy group or an alkoxy group.

(Formula 1-2) ($R4R5SiXO_{1/2}$)

The unit represented by ($R4R5SiO_{2/2}$) may include a moiety surrounded by dashed lines of a unit represented by formula (1-b) shown below, and may also include a moiety surrounded by dashed lines of a unit represented by formula (1-2-b) shown below. Namely, a unit including groups represented by R4 and R5, and an alkoxy group or a hydroxy group remaining at a terminal position is also included in the unit represented by ($R4R5SiO_{2/2}$). Specifically, in the case where the alkoxy group has been converted into a partial skeleton of the siloxane bond, the unit represented by ($R4R5SiO_{2/2}$) corresponds to the moiety surrounded by dashed lines of a unit represented by the formula (1-b) shown below. In the case where an unreacted alkoxy group remains, or where the alkoxy group has been converted into a hydroxy group, the unit represented by ($R4R5SiO_{2/2}$) including the remaining alkoxy group or hydroxy group corresponds to the moiety surrounded by dashed lines of a unit represented by the formula (1-2-b) shown below.

[Chem. 10]

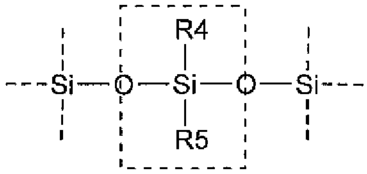

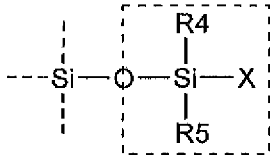

· · ·Formula (1-b) · · ·Formula (1-2-b)

In the formulae (1-2) and (1-2-b), X represents OH or OR, and the OR represents a linear or branched $C_1$ to

$C_4$ alkoxy group. R4 and R5 in the formulae (1-b), (1-2), and (1-2-b) are respectively the same groups as the R4 and R5 in the formulae (1A) and (1B).

In the first silicone resin represented by the formula (1A) or the formula (1B), a unit represented by ($R6SiO_{3/2}$) (hereinafter, also referred to as trifunctional unit) may include a structure represented by formula (1-3) or (1-4) shown below; namely a structure in which the two oxygen atoms each bonded to a silicon atom in the trifunctional unit each constitute a hydroxy group or an alkoxy group, or a structure in which one of the oxygen atoms bonded to a silicon atom in the trifunctional unit constitutes a hydroxy group or an alkoxy group.

Formula (1-3) ($R6SiX_2O_{1/2}$)

Formula (1-4) ($R6SiXO_{1/2}$)

The unit represented by ($R6SiO_{3/2}$) includes a moiety surrounded by dashed lines of a unit represented by formula (1-c) shown below, and may further include a moiety surrounded by dashed lines of a unit represented by formula (1-3-c) or (1-4-c) shown below. Namely, a unit including a group represented by R6 and further including an alkoxy group or a hydroxy group remaining at a terminal position is also included in the unit represented by ($R6SiO_{3/2}$).

[Chem. 11]

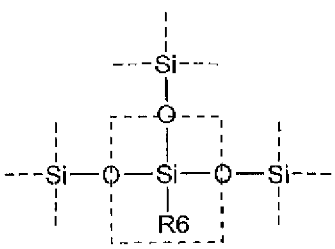

···Formula (1-c)

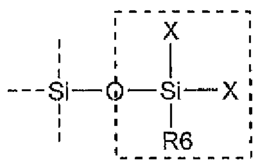

···Formula (1-3-c)

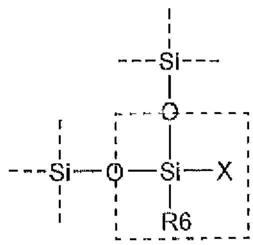

···Formula (1-4-c)

In the formulae (1-3), (1-3-c), (1-4), and (1-4-c), X represents OH or OR, and the OR represents a linear or branched C1 to C4 alkoxy group. R6 in the formulae (1-c), (1-3), (1-3-c), (1-4), and (1-4-c) is the same group as the R6 in the formulae (1A) and the formula (1B).

In the first silicone resin represented by the formula (1B), the unit represented by ($R7R8R9R10Si_2R110_{2/2}$) may include a structure represented by formula (1-5) shown below;, namely a structure in which one of oxygen atoms bonded to a silicon atom in the unit ($R7R8R9R10Si_2R110_{2/2}$) constitutes an hydroxy group or an alkoxy group.

Formula (1-5) ($R7R8R9R10Si_2R11XO_{1/2}$)

The unit represented by ($R7R8R9R10Si_2R110_{2/2}$) includes a moiety surrounded by dashed lines of a unit represented by formula (1-d) shown below, and may further include a moiety surrounded by dashed lines of a unit represented by formula (1-5-d) shown below. Namely, a unit including groups represented by R7, R8, R9, R10, and R11, and further including an alkoxy group or a hydroxy group remaining at a terminal position is also included in the unit represented by ($R7R8R9R10Si_2R11O_{2/2}$).

[Chem. 12]

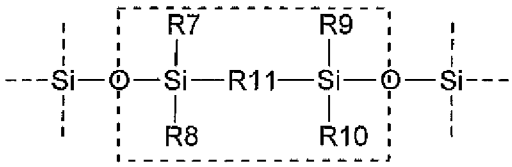

···Formula (1-d)

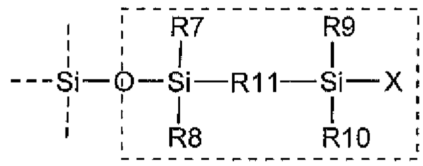

···Formula (1-5-d)

In the formulae (1-5) and (1-5-d), X represents OH or OR, and the OR represents a linear or branched C1 to C4 alkoxy group. R7 to R11 in the formulae (1-d), (1-5), and (1-5-d) are the same groups as the R7 to R11 in the formula (1B).

The linear or branched $C_1$ to $C_4$ alkoxy group in the formulae (1-b) to (1-d), (1-2) to (1-5), (1-2-b), (1-3-c), (1-4-c), and (1-5-d) is not particularly limited, and examples thereof include a methoxy group, an ethoxy group, an n-propoxy group, an n-butoxy group, an isopropoxy group, an isobutoxy group, a sec-butoxy group, and a t-butoxy group.

In the formula (1A), a value of a/(a+b+c) is 0.05 at minimum and 0.50 at maximum. In the case where a/(a+b+c) satisfies the minimum value and the maximum value, the die bonding material can have further enhanced heat resistance, and can be prevented from peeling off. In the formula (1A), a preferable minimum value of a/ (a+b+c) is 0.10, more preferably 0.15, and a preferable maximum value is 0.45, and more preferably 0.40.

In the formula (1A), a value of b/(a+b+c) is 0 at minimum, and 0.40 at maximum. In the case where b/(a+b+c) satisfies the maximum value, the storage elastic modulus of the die bonding material at high temperatures can be enhanced. In the case where b is 0, and b/(a+b+c) is 0, the unit of ($R4R5SiO_{2/2}$) does not exist in the formula (1A).

In the formula (1A), a value of c/(a+b+c) is 0.30 at minimum, and 0.80 at maximum. In the case where c/(a+b+c) satisfies the minimum value, the storage elastic modulus of the die bonding material at high temperatures can be enhanced. In the case where c/(a+b+c) satisfies the maximum value, the die bonding material has high heat resistance, and the thickness of a cured product of the die bonding material under high temperature conditions is less likely to decrease. In the formula (1A), a preferable minimum value of c/(a+b+c) is 0.35, more preferably 0.40, and a preferable upper value is 0.75.

In the formula (1B), a value of a/(a+b+c+d) is 0.05 at minimum and 0.50 at maximum. In the case where a/(a+b+c+d) satisfies the minimum value and the maximum value, the die bonding material can have further enhanced heat resistance, and can be further prevented from peeling off. In the formula (1B), a preferable minimum value of a/ (a+b+c+d) is 0.10, more preferably 0.15, and a preferable maximum value is 0.45, more preferably 0.40.

In the formula (1B), a value of b/(a+b+c+d) is 0 at minimum and 0.40 at maximum. In the case where b/(a+b+c+d) satisfies the maximum value, the storage elastic modulus of the die bonding material at high temperature can be enhanced. In the case where b is 0, and a value of b/(a+b+c+d) is 0, the unit of ($R4R5RSiO_{2/2}$) does not exist in the formula (1B).

In the formula (1B), a value of c/ (a+b+c+d) is 0.30 at minimum and 0.80 at maximum. In the case where c/(a+b+c+d) satisfies the minimum value, the storage elastic modulus of the die bonding material at high temperature can be enhanced. In the case where c/ (a+b+c+d) satisfies the maximum value, the die bonding material has high heat resistance, and the thickness of a cured product of the die bonding material under high temperature conditions is less likely to decrease. A preferable minimum value of c/(a+b+c+d) is 0.35, more preferably 0.40, and a preferable maximum value is 0.75.

In the formula (1B), a value of d/(a+b+c+d) is 0.01 at minimum and 0.40 at maximum. In the case where d/(a+b+c+d) satisfies the minimum value and the maximum value, a die bonding material which has high gas barrier property against corrosion gases, and is less likely to crack or peel off even used in harsh environments can be provided. In terms of achieving a die bonding material for an optical semiconductor device which has a higher gas barrier property against corrosion gases, and is far less likely to crack or peel off even used in harsh environments, in the formula (1B), a value of d/(a+b+c+d) is preferably 0.03 and more preferably 0.05 at minimum, and is preferably 0.35 and more preferably 0.30 at maximum.

The $^{29}$Si-nuclear magnetic resonance analysis (hereinafter, also referred to as NMR) of the first silicone resin using tetramethylsilane (hereinafter, also referred to as TMS) as standard shows that peaks corresponding to the unit represented by $(R1R2R3SiO_{1/2})_a$ appear in a range of about +10 to -5 ppm in the formula (1A) and the formula (1B); peaks corresponding to the respective bi-functional units represented by ($R4R5SiO_{2/2}$) in the formula (1A) and the formula (1B), and the formula (1-2) appear in a range of about -10 to -50 ppm; peaks corresponding to the respective trifunctional units represented by $(R6SiO_{3/2})_c$ in the formula (1A) and the formula (1B), the formulae (1-3) and (1-4) appear in a range of about -50 to -80 ppm; and peaks corresponding to the respective units represented by $(R7R8R9R10Si_2R11O_{2/2})_d$ in the formula (1B), and the (1-5) appear in a range of about 0 to -5 ppm.

By the $^{29}$Si-NMR analysis and comparison of the peak areas of respective signals, the ratios of the respective units in the formula (1A) and the formula (1B) can be determined.

If the $^{29}Si$-NMR analysis using TMS as standard does not identify the units in the formula (1A) and the formula (1B), results of $^{1}H$-NMR analysis are optionally used in addition to the result of the $^{29}Si$-NMR analysis so that the ratios of the respective units in the formula (1A) and the formula (1B) can be determined.

(Second silicone resin)

A second silicone resin contained in the die bonding material for an optical semiconductor device according to the present invention contains an alkenyl group. The alkenyl group is directly bonded to a silicon atom. A carbon atom in the carbon-carbon double bond of the alkenyl group may be bonded to a silicon atom, or a carbon atom other than the carbon atom in the carbon-carbon double bond of the alkenyl group may be bonded to a silicon atom.
In terms of further enhancing the gas barrier property of the die bonding material, the second silicone resin preferably includes an alkenyl group and an aryl group. Examples of the aryl group include unsubstituted phenyl groups, substituted phenyl groups, unsubstituted phenylene groups, and substituted phenylene groups.
In terms of achieving a die bonding material having far more enhanced gas barrier property, the second silicone resin is preferably a second silicone resin represented by formula (51A) or formula (51B) shown below. It is noted that, a second silicone resin other than the second silicone resin represented by the formula (51A) or the formula (51B) shown below may be used as the second silicone resin. The silicone resin represented by the formula (51B) shown below may contain a phenylene group or may not contain a phenylene group. The second silicone resin may be used solely, or two or more kinds thereof may be used in combination.
**[Chem. 13]** $(R51\,R52R53SiO_{1/2})_p(R54R55SiO_{2/2})_q(R56SiO_{3/2})_r$ **Formula (51A)**

In the formula (51A), p, q, and r satisfy the following equations: p/(p+q+r) = 0.05 to 0.50; q/(p+q+r) = 0 to 0.40; and r/(p+q+r) = 0.30 to 0.80, and at least one of R51 to R56 represents a phenyl group, at least one of R51 to R56 represents an alkenyl group, and the rest of the R51 to R56 other than phenyl groups and alkenyl groups represent $C_1$ to $C_8$ hydrocarbon groups. In the formula (51A), a unit represented by $(R54R55SiO_{2/2})$ and a unit represented by $(R56SiO_{3/2})$ each may contain an alkoxy group or a hydroxy group.
**[Chem. 14]** $(R51R52R5SSiO_{1/2})_p(R54R55SiO_{2/2})_q(R56SiO_{3/2})_r(R57R58R59R60Si_2R61O_{2/2})_s$ **Formula (51B)**

In the formula (51B), p, q, r and s satisfy the following equations: p/(p+q+r+s) = 0.05 to 0.50; q/(p+q+r+s) = 0 to 0.40; r/(p+q+r+s) = 0.30 to 0.80; and s/(p+q+r+s) = 0.01 to 0.40, and at least one of R51 to R56 represents a phenyl group, at least one of R51 to R56 represents an alkenyl group, and the rest of the R51 to R56 other than phenyl groups and alkenyl groups represent $C_1$ to $C_8$ hydrocarbon groups, R57 to R60 each represent a $C_1$ to $C_8$ hydrocarbon group, and R61 represents a $C_1$ to $C_8$ bivalent hydrocarbon group. In the formula (51B), a unit represented by $(R54R55SiO_{2/2})$, a unit represented by $(R56SiO_{3/2})$, and a unit represented by $(R57R58R59R60Si_2R61O_{2/2})$ may each contain an alkoxy group or may contain a hydroxy group.
The formula (51A) and the formula (51B) each are an average composition formula. Hydrocarbon groups in the formula (51A) and the formula (51B) may be linear or branched chains. R51 to R56 in the formula (51A) and the formula (51B) may be the same or different from one another. R57 to R60 in the formula (51B) may be the same or different from one another.
The oxygen atom part in the unit represented by $(R54R55SiO_{2/2})$ in the formula (51A) and the formula (51B), the oxygen atom part in the unit represented by $(R56SiO_{3/2})$, and the oxygen atom part in the unit represented by $(R57R58R59R60Si_2R61O_2)$ each are an oxygen atom part forming a siloxane bond, an oxygen atom part in the alkoxy group, or an oxygen atom part in the hydroxy group.
Examples of the alkenyl group in the formula (51A) and the formula (51B) include a vinyl group, an allyl group, a butenyl group, a pentenyl group, and a hexenyl group. In terms of further enhancing the gas barrier property, the alkenyl group in the second silicone resin and the alkenyl group in the formula (51A) and the formula (51B) is preferably a vinyl group or an allyl group, and more preferably a vinyl group.
The $C_1$ to $C_8$ hydrocarbon group in the formula (51A) and the formula (51B) is not particularly limited, and examples thereof include a methyl group, an ethyl group, an n-propyl group, an n-butyl group, an n-pentyl group, an n-hexyl group, an n-heptyl group, an n-octyl group, an isopropyl group, an isobutyl group, a sec-butyl group, a t-butyl group, an isopentyl group, a neopentyl group, a t-pentyl group, an isohexyl group, and a cyclohexyl group. The $C_1$ to $C_8$ bivalent hydrocarbon group in the formula (51B) is not particularly limited, and examples thereof include a methylene group, an ethylene group, a propylene group, a butylene group, a pentylene group, a hexylene group, a cyclohexylene group, and a phenylene group.

The aryl group content in the second silicone resin represented by the formula (51A) or the formula (51B) calculated based on formula (X51) shown below is preferably not less than 10 mol% and is preferably not more than 50 mol%. The aryl group content of not less than 10 mol% further enhances the gas barrier property. The aryl group content of not more than 50 mol% tends not to cause peeling of the die bonding material. In terms of achieving more enhanced gas barrier property, the aryl group content is more preferably not less than 20 mol%. In terms of further preventing peeling of the die bonding material, the aryl group content is more preferably not more than 40 mol%.

(Formula X51)

[Aryl group content (mol%)] = [(Average number of aryl group included in one molecule of the second silicone resin whose average composition is represented by the formula (51A) or the formula (51B) × Molecular weight of the aryl group)/(Number average molecular weight of the second silicone resin whose average composition is represented by the formula (51A) or the formula (51B))] × 100

In the case of using the second silicone resin represented by the formula (51A) and containing a phenyl group, the aryl group in the formula (X51) is a phenyl group. The aryl group content shows the phenyl group content.

In the case of using the silicone resin represented by the formula (51A) and containing a phenyl group and a phenylene group, the aryl group in the formula (X51) is a phenyl group and a phenylene group, and the aryl group content is a total content of the phenyl group and the phenylene group.

In the case of using the silicone resin represented by the formula (51B) and containing a phenyl group but not containing a phenylene group, the aryl group in the formula (X51) is a phenyl group. The aryl group content shows the phenyl group content.

In terms of further enhancing the gas barrier property, the unit ($R57R58R59R60Si_2R61O_{2/2}$) in the formula (51B) is preferably a unit represented by formula (51b-1) shown below. The unit represented by the formula (51b-1) includes a phenylene group, and the phenylene group is a substituted or unsubstituted phenylene group.

**[Chem. 15]**

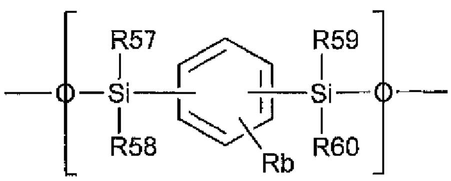

···Formula (51b-1)

In the formula (51b-1), Rb represents a hydrogen atom or a $C_1$ to $C_8$ hydrocarbon group, and R57 to R60 each represent a $C_1$ to $C_8$ hydrocarbon group. The hydrocarbon group may be a linear or branched chain. A binding site of each of the three groups to the benzene ring in the formula (51b-1) is not particularly limited.

The unit ($R57R58R59R60Si_2R61O_{2/2}$) in the formula (5 1B) is preferably a unit represented by formula (51b-2) shown below. The unit represented by the formula (51b-2) includes a phenylene group, and the phenylene group is a substituted or unsubstituted phenylene group. A binding site of the Rb to the benzene ring in the formula (51b-2) is not particularly limited.

[Chem. 16]

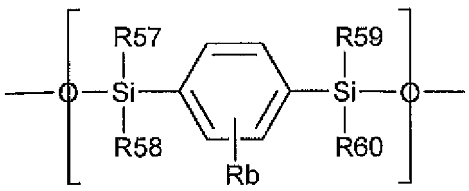

···Formula (51b-2)

In the formula (51b-2), Rb represents a hydrogen atom or a $C_1$ to $C_8$ hydrocarbon group, and R57 to R60 each represent a $C_1$ to $C_8$ hydrocarbon group.

The unit ($R57R58R59R60Si_2R61O_{2/2}$) in the formula (51B) is more preferably a unit represented by formula (51b-3) shown below. The unit represented by the formula (51b-3) includes a phenylene group, and the phenylene group is an unsubstituted phenylene group.

[Chem. 17]

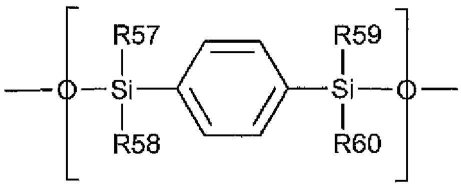

···Formula (51b-3)

In the formula (51b-3), R57 to R60 each represent a $C_1$ to $C_8$ hydrocarbon group.

In the second silicone resin represented by the unit ($R54R55SiO_{2/2}$) (hereinafter, also referred to as a bi-functional unit) in the formula (51A) or (51B) may include a structure represented by formula (51-2) shown below, namely a structure in which one of oxygen atoms bonded to a silicon atom constitutes an hydroxy group or an alkoxy group.

Formula (51-2) ($R54R55SiXO_{1/2}$)

The unit represented by ($R54R55SiO_{2/2}$) may include a moiety surrounded by dashed lines of a unit represented by formula (51-b) shown below, and may further include a moiety surrounded by dashed lines of a unit represented by formula (51-2-b) shown below. Namely, a unit including groups represented by R54 and R55, and further including an alkoxy group or a hydroxy group remaining at a terminal position may also be included in the unit represented by ($R54R55SiO_{2/2}$).

[Chem. 18]

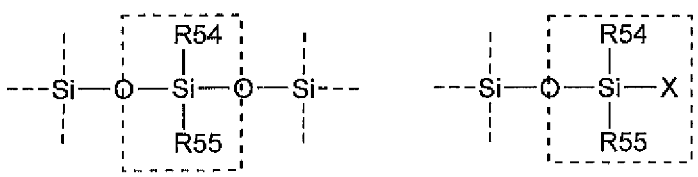

···Formula (51-b) ···Formula (51-2-b)

In the formulae (51-2) and (51-2-b), X represents OH or OR, and the OR represents a linear or branched $C_1$ to $C_4$ alkoxy group. R54 and R55 in the formulae (51-b), (51-2), and (51-2-b) are respectively the same groups as the R54 and R55 in the formulae (51A) or (51B).

In the second silicone resin represented by the formula (51A) or (51B), a unit represented by ($R56SiO_{3/2}$) (hereinafter, also referred to as trifunctional unit) may include a structure represented by formula (51-3) or (51-4) shown

below; namely a structure in which the two oxygen atoms each bonded to a silicon atom in the trifunctional unit constitute a hydroxy group or an alkoxy group, or a structure in which one of the oxygen atoms bonded to a silicon atom in the trifunctional unit constitutes a hydroxy group or an alkoxy group.

Formula (51-3) $(R56SiX_2O_{1/2})$

Formula (51-4) $(R56SiXO_{2/2})$

The unit represented by $(R56SiO_{3/2})$ includes a moiety surrounded by dashed lines of a unit represented by formula (51-c) shown below, and may further include a moiety surrounded by dashed lines of a unit represented by formula (51-3-c) or (51-4-c) shown below. Namely, a unit including a group represented by R56 and further including an alkoxy group or a hydroxy group remaining at a terminal position is also included in the unit represented by $(R56SiO_{3/2})$.

[Chem. 19]

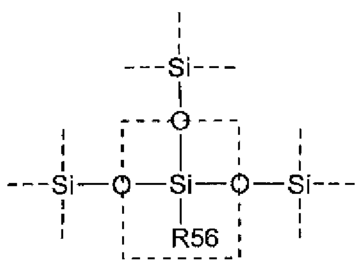

···Formula (51-c)

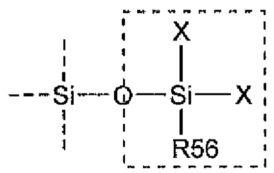

···Formula (51-3-c)

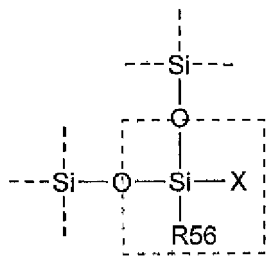

···Formula (51-4-c)

In the formulae (51-3), (51-3-c), (51-4), and (51-4-c), X represents OH or OR, and the OR represents a linear or branched C1 to C4 alkoxy group. R56 in the formulae (51-c), (51-3), (51-3-c), (51-4), and (51-4-c) is the same group as the R56 in the formulae (51A) and (51B).

In the second silicone resin represented by the formula (51B), the unit represented by $(R57R58R59R60Si_2R61O_{2/2})$ may include a structure represented by formula (51-5) shown below, namely a structure in which one of oxygen atoms bonded to a silicon atom in the unit $(R57R58R59R60Si_2R61O_{2/2})$ constitutes an hydroxy group or an alkoxy group.

Formula (51-5) $(R57R58R59R60Si_2XR61O_{1/2})$

The unit represented by $(R57R58R59R60Si_2R61O_{2/2})$ includes a moiety surrounded by dashed lines of a unit represented by formula (51-d) shown below, and may further include a moiety surrounded by dashed lines of a unit represented by formula (51-5-d) shown below. Namely, a unit including groups represented by R57, R58, R59, R60, and R61, and further including an alkoxy group or a hydroxy group remaining at a terminal position is also included in the unit represented by $(R57R58R59R60Si_2R61O_{2/2})$.

[Chem. 20]

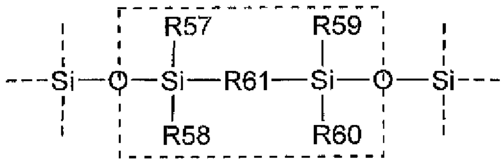

···Formula (51-d)

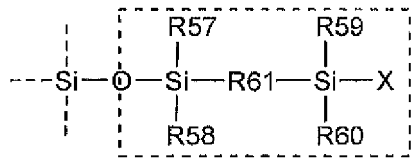

···Formula (51-5-d)

In the formulae (51-5) and (51-5-d), X represents OH or OR, and the OR represents a linear or branched C1 to C4 alkoxy group. R57 to R61 in the formulae (51-d), (51-5), and (51-5-d) are the same groups as the R57 to R61 in the formula (51B).

The linear or branched $C_1$ to $C_4$ alkoxy group in the formulae (51-b) to (51-d), (51-2) to (51-5), (51-2-b), (51-3-c), (51-4-c), and (51-5-d) is not particularly limited, and examples thereof include a methoxy group, an ethoxy group, an n-propoxy group, an n-butoxy group, an isopropoxy group, an isobutoxy group, a sec-butoxy group, and a t-butoxy group.

In the formula (51A), a value of p/(p+q+r) is 0.05 at minimum and 0.50 at maximum. In the case where p/(p+q+r) satisfies the minimum value and the maximum value, the die bonding material can have further enhanced heat resistance, and can be further prevented from peeling off. In the formula (51A), a preferable minimum value of p/(p+q+r) is 0.1, more preferably 0.15, and a preferable maximum value is 0.45, more preferably 0.40.

In the formula (51A), a value of q/(p+q+r) is 0 at minimum and 0.40 at maximum. In the case where q/(p+q+r) satisfies the maximum value, the storage elastic modulus of the die bonding material at high temperatures can be enhanced. In the formula (51A), a preferable maximum value of q/(p+q+r) is 0.35, and more preferably 0.30. In the case where q is 0, and q/(p+q+r) is 0, the unit of ($R54R55SiO_{2/2}$) does not exist in the formula (51A).

In the formula (51A), a value of r/(p+q+r) is 0.30 at minimum and 0.80 at maximum. In the case where r/(p+q+r) satisfies the minimum value, the storage elastic modulus of the die bonding material at high temperatures can be enhanced. In the case where r/(p+q+r) satisfies the maximum value, the die bonding material can have further enhanced heat resistance, and the thickness of a cured product of the die bonding material is less likely to decrease under high temperature conditions.

In the formula (51B) , a value of p/(p+q+r+s) is 0. 05 at minimum and 0.50 at maximum. In the case where p/(p+q+r+s) satisfies the maximum value, the die bonding material can have further enhanced heat resistance, and can be prevented from peeling off.

In the formula (51B), a value of q/(p+q+r+s) is 0 at minimum and 0.40 at maximum. In the case where q/(p+q+r+s) satisfies the maximum value, the storage elastic modulus of the die bonding material at high temperatures can be enhanced. In the case where q is 0, and q/ (p+q+r+s) is 0, the unit of ($R54R55SiO_{2/2}$) does not exist in the formula (51B) .

In the formula (51B) , a value of r/(p+q+r+s) is 0.30 at minimum and 0.80 at maximum. In the case where r/(p+q+r+s) satisfies the maximum value, the storage elastic modulus of the die bonding material at high temperatures can be enhanced. In the case where r/ (p+q+r+s) satisfies the maximum value, the die bonding material can have further enhanced heat resistance, and the thickness of a cured product of the die bonding material is less likely to decrease under high temperature conditions.

In the formula (51B), a value of s/ (p+q+r+s) is 0.01 at minimum and 0.40 at maximum. In the case where s/(p+q+r+s) satisfies the minimum value and the maximum value, the die bonding material for an optical semiconductor device can be obtained which has high gas barrier property against corrosive gas, and is less likely to crack or peel off even when used in harsh environments. In terms of obtaining a die bonding material for an optical semiconductor device which has higher gas barrier property, and is far less likely to crack or peel off even when used in harsh environments, a preferable minimum value of s/(p+q+r+s) in the formula (51B) is 0.03, more preferably 0.05, and a preferable maximum value of s/ (p+q+r+s) is 0.35, more preferably 0.30.

The $^{29}$Si-nuclear magnetic resonance analysis (hereinafter, also referred to as NMR) of the second silicone resin using tetramethylsilane (hereinafter, also referred to as TMS) as standard shows that peaks corresponding to the unit represented by $(R51R52R53SiO_{1/2})_p$ in the formula (51A) and the formula (51B) appear in a range of about +10 to -5 ppm; peaks corresponding to the respective bi-functional units represented by $(R54R55SiO_{2/2})_q$ in the formula (51A) and the formula (51B), and the formula (51-2) appear in a range of about -10 to -50 ppm; peaks corresponding to the respective trifunctional units represented by $(R56SiO_{3/2})_r$ in the formula (51A) and the formula (51B), and the formulae (51-3) and (51-4) appear in a range of about -50 to -80 ppm; and peaks corresponding to the respective units represented by ($R57R58R59R60Si_2R61O_{2/2}$) in the formula (51B), and the (51-5) appear in a range of about 0 to -5 ppm.

By the $^{29}$Si-NMR analysis and comparison of the peak areas of respective signals, the ratios of the respective units in the formula (51A) and the formula (51B) can be determined.

If the $^{29}$Si-NMR analysis using TMS as standard does not identify the units in the formula (51A) and the formula (51B) , results of $^{1}$H-NMR analysis are optionally used in addition to the result of the $^{29}$Si-NMR analysis so that the ratios of the respective units in the formula (51A) and the formula (51B) can be determined.

The amount of the second silicone resin based on 100 parts by weight of the first silicone resin is preferably from 10 parts by weight to 400 parts by weight. The amount of the first silicone resin and the amount of the second silicone resin within the above range can provide a die bonding material having an enhanced storage elastic modulus and an enhanced gas barrier property. In terms of obtaining a die bonding material having further enhanced storage elastic modulus and the further enhanced gas barrier property, the minimum amount of the second silicone resin based on 100 parts by weight of the first silicone resin is more preferably 30 parts by weight and further preferably 50 parts by weight, and the maximum amount thereof is more preferably 300 parts by weight and further preferably 200 parts by weight.

In terms of achieving a die bonding material with far more enhanced gas barrier property, preferably, the die bonding material for an optical semiconductor device according to the present invention includes at least one of the first silicone resin represented by the formula (1B) and the second silicone resin represented by the formula (51B).

(Other behaviors and production methods of the first and second silicone resins)

The minimum amount of the alkoxy group in the first and second silicone resins is preferably 0.5 mol% and more preferably 1 mol%, and the maximum amount thereof is preferably 10 mol% and more preferably 5 mol%. The alkoxy group content in the aforementioned preferable ranges can further enhance the adhesion property of the die bonding material.

The alkoxy group content satisfying the preferable minimum amount further enhances the adhesion property of the die bonding material. The alkoxy group content satisfying the preferable maximum amount increases the storage stability of the first and second silicone resins and the die bonding material, and further enhances the heat resistance of the die bonding material.

The alkoxy group content refers to the amount of the alkoxy group contained in the average composition formula of the first and second silicone resins.

The first and second silicone resins each preferably do not contain a silanol group. If the first and second silicone resins each do not contain a silanol group, the storage stability of the first and second silicone resins and the die bonding material increase. The silanol group can be reduced by heating in vacuo. The silanol group content can be measured by infrared spectroscopy.

The minimum number average molecular weight (Mn) of the first and second silicone resins is preferably 500, more preferably 800, and still more preferably 1000. The maximum number average molecular weight (Mn) thereof is preferably 50000, and more preferably 15000. The number average molecular weight satisfying the preferable minimum levels reduces components volatilized during thermal curing. Thus, the thickness of a cured product of the die bonding material is less likely to decrease under high temperature conditions. The number average molecular weight satisfying the preferable maximum levels leads to easier viscosity control.

The number average molecular weight (Mn) was a value determined by gel permeation chromatography (GPC) using polystyrene as a standard. The number average molecular weight (Mn) means a value determined using a measuring apparatus produced by Waters (Column: two columns, Shodex GPC LF-804 (length: 300 mm), Temperature: 40°C, Flow rate: 1 mL/min, Solvent: tetrahydrofuran, Standard material: polystyrene).

Methods of synthesizing the first and second silicone resins are not particularly limited, and a method including hydrolysis of an alkoxysilane compound and condensation thereof, and a method including hydrolysis of a chlorosilane compound and condensation thereof may be exemplified. In terms of better control of the reactions, a method including hydrolysis of an alkoxysilane compound and condensation thereof is preferred.

Examples of the method including hydrolysis of an alkoxysilane compound and condensation thereof include a method of reacting an alkoxysilane compound in the presence of water and an acidic or basic catalyst. A disiloxane compound may be hydrolyzed and used.

Examples of the organic silicon compound to introduce a phenyl group into the first and second silicone resins include triphenylmethoxysilane, triphenylethoxysilane, diphenyldimethoxysilane, diphenyldiethoxysilane, methyl(phenyl) dimethoxysilane, and phenyl trimethoxysilane.

Examples of an organic silicon compound to introduce the unit ($R57R58R59R60Si_2R61O_{2/2}$) or the unit ($R7R8R9R10Si_2R11O_{2/2}$) into the first and second silicone resins include 1,4-bis(dimethylmethoxysilyl)benzene, 1,4-bis(diethylmethoxysilyl)benzene, 1,4-bis(ethoxyethylmethylsilyl)benzene, 1,6-bis(dimethylmethoxysilyl)hexane, 1,6-bis (diethylmethoxysilyl)hexane, and 1,6-bis(ethoxyethylmethylsilyl)hexane.

Examples of the organic silicon compound to introduce an alkenyl group into the first and second silicone resins

include vinyltrimethoxysilane, vinyltriethoxysilane, vinylmethyldimethoxysilane, methoxydimethylvinylsilane, and 1,3-divinyl-1,1,3,3-tetramethyldisiloxane.

Examples of the organic silicon compound to introduce a hydroxy atom bonded to a silicon atom into the first silicone resin include trimethoxysilane, triethoxysilane, methyldimethoxysilane, methyldiethoxysilane, and 1,1,3,3-tetramethyldisiloxane.

Examples of other organic silicon compounds which can be used to obtain the first and second silicone resins include trimethylmethoxysilane, trimethylethoxysilane, dimethyldimethoxysilane, dimethyldiethoxysilane, isopropyl(methyl)dimethoxysilane, cyclohexyl(methyl)dimethoxysilane, methyltrimethoxysilane, methyltriethoxysilane, ethyltrimethoxysilane, ethyltriethoxysilane, hexyltrimethoxysilane, and octyltrimethoxysilane.

Examples of the acidic catalyst include inorganic acids, organic acids, acid anhydrides of inorganic acids and derivatives thereof, and acid anhydrides of organic acids and derivative thereof.

Examples of the inorganic acids include hydrochloric acid, phosphoric acid, boric acid and carbonic acid. Examples of the organic acids include formic acid, acetic acid, propionic acid, butyric acid, lactic acid, malic acid, tartaric acid, citric acid, oxalic acid, malonic acid, succinic acid, glutaric acid, adipionic acid, fumaric acid, maleic acid, and oleic acid.

Examples of the basic catalyst include alkali metal hydroxides, alkali metal alkoxides, and silanol compounds of alkali metal.

Examples of the alkali metal hydroxide include sodium hydroxide, potassium hydroxide, and cesium hydroxide. Examples of the alkali metal alkoxides include sodium-t-butoxide, potassium-t-butoxide, and cesium-t-butoxide.

Examples of the silanol compounds of the alkali metal include sodium silanolate compounds, potassium silanolate compounds, and cesium silanolate compounds. Potassium-based catalysts or cesium-based catalysts are preferable among the examples.

(Catalyst for hydrosilylation reaction)

The catalyst for hydrosilylation reaction contained in the die bonding material for an optical semiconductor device according to the present invention is a catalyst to promote hydrosilylation reaction between the hydrogen atom bonded to a silicon atom in the first silicone resin and the alkenyl group in the second silicone resin.

As the catalyst for hydrosilylation reaction, various catalysts capable of promoting hydrosilylation reaction can be used. The catalysts for hydrosilylation reaction may be used alone or two or more kinds thereof may be used in combination.

Examples of the catalyst for hydrosilylation reaction include platinum-based catalysts, rhodium-based catalysts, and palladium-based catalysts. For higher transparency of the die bonding material, platinum-based catalysts are preferred.

Examples of the platinum-based catalysts include platinum powder, chloroplatinic acid, platinum-alkenylsiloxane complex, platinum-olefin complex, and platinum-carbonyl complex. In particular, platinum-alkenylsiloxane complex or platinum-olefin complex is preferable.

Examples of the alkenylsiloxane in the platinum-alkenylsiloxane complex include 1,3-divinyl-1,1,3,3-tetramethyldisiloxane, and 1,3,5,7-tetramethyl-1,3,5,7-tetravinylcyclotetrasiloxane. Examples of the olefin in the platinum-olefin complex include allyl ether, and 1,6-heptadiene.

Preferably, alkenylsiloxane, organosiloxane oligomer, allyl ether or olefin is added to the platinum-alkenylsiloxane complex or the platinum-olefin complex because the stability of the platinum-alkenylsiloxane complex and the platinum-olefin complex can be enhanced. The alkenylsiloxane is preferably 1,3-divinyl-1,1,3,3-tetramehyldisiloxaine. The organosiloxane oligomer is preferably dimethylsiloxane oligomer. The olefin is preferably 1,6-heptadiene.

The amount of the catalyst for hydrosilylation reaction in 100 wt% of the die bonding material is preferably in a range of 0.01 to 0.5 parts by weight. The amount of the catalyst for hydrosilylation reaction of not less than the minimum value makes it easier to sufficiently cure the die bonding material, and can further enhance the gas barrier property of the die bonding material. The amount of the catalyst for hydrosilylation reaction of not more than the maximum value tends to further prevent coloring of the die bonding material. The amount of the catalyst for hydrosilylation reaction is more preferably not less than 0.02 parts by weight, and is more preferably not more than 0.3 parts by weight.

(Substance (X))

The substance (X) included in the die bonding material for an optical semiconductor device according to the present invention is at least one of anhydrous magnesium carbonate (X1) represented by chemical formula $MgCO_3$ not containing crystal water and coated bodies (X2) including the anhydrous magnesium carbonate and an organic resin, a silicone resin, or silica coated on the surface thereof. As the substance (X), only the anhydrous magnesium carbonate (X1) may be used, or only the coated body (X2) may be used, or both of the anhydrous magnesium carbonate (X1) and

the coated body (X2) may be used.

A coated body including the anhydrous magnesium carbonate and a silicone resin or silica coated on the surface thereof is preferable. A coated body including the anhydrous magnesium carbonate and a silicone resin coated on the surface thereof is more preferable.

Use of the substance (X) as a filler can sufficiently increase the thermal conductivity and the heat resistance of a cured product of the die bonding material. Moreover, use of the substance (X) prevents a cured product of the die bonding material from cracking.

Natural products and synthesized products of the anhydrous magnesium carbonate (X1) represented by chemical formula $MgCO_3$ not containing crystal water exist. Since the natural products contain impurities, use of the natural products may result in instability of the physical properties such as heat resistance. For this reason, the anhydrous magnesium carbonate (X1) is preferably a synthesized product.

The coated body (X2) has a core-shell structure including the anhydrous magnesium carbonate (X1) as a core, and a coating layer formed of an organic resin, a silicone resin or silica as a core. The coated body (X2) has high dispersibility in a resin due to the coating layer. Moreover, use of the coated body (X2) having the coating layer can further enhance the resistance to moist heat of a cured product of the die bonding material.

A method of coating the surface of the anhydrous magnesium carbonate (X1) with the coating layer is not particularly limited. Examples of the method include: a method including dispersing the anhydrous magnesium carbonate (X1) in a solution containing an organic resin, a silicone resin, or a silane coupling agent as a silica material dissolved therein and then spray-drying the resulting dispersion liquid; a method including dispersing the anhydrous magnesium carbonate (X1) in a solution containing an organic resin or a silicone resin dissolved therein and then adding a poor solvent of an organic resin or a silicone resin to the resulting dispersion liquid so that the organic resin or polysiloxane is deposited on the surface of the anhydrous magnesium carbonate (X1) ; and a method including reacting a polymerizable monomer such as acrylic resin, a styrene resin, or a low molecular weight silane in a solvent containing the anhydrous magnesium carbonate (X1) dispersed therein, thereby allowing the organic resin, the silicone resin, or the silica which is polymerized and thus becomes insoluble in the solvent to deposit on the surface of the anhydrous magnesium carbonate (X1), or the like.

The organic resin is not particular limited as long as it can coat the surface of the anhydrous magnesium carbonate (X1). The organic resin may be thermosetting resins or thermoplastic resins.

Specific examples of the organic resin include (meth) acrylic-based resins, stylene-based resins, urea resins, melamine resins, phenol-based resins, thermoplastic urethane-based resins, thermosetting urethane-based resins, epoxy-based resins, thermoplastic polyimide-based resins, thermosetting polyimide-based resins, aminoalkyd-based resins, phenoxy resins, phthalate resins, polyamido-based resins, ketone-based resins, norbornene-based resins, polyphenylene sulfide, polyarylate, polysulfone, polyethersulfone, polyetheretherketone, polyetherketone, thermoplastic polyimide, thermosetting polyimide, penzoxazine, and a reaction product of polybenzoxazol and benzoxazine. Preferable examples among the above examples are (meth)acrylic-based resins and stylene-based resins considering that they have plenty kinds of monomers, can design various types of coating layers, and can easily control reactions caused by heat, light, or the like.

The stylene-based resins are not particularly limited. Examples of the stylene-based resins include stylene, o-methylstylene, m-methylstylene, p-methylstylene, p-methoxystylene, p-phenylstylene, p-chlorostylene, p-ethylstylene, p-n-butylstylene, p-tert-butylstylene, p-n-hexylstylene, p-n-octylstylene, p-n-nonylstylene, p-n-decylstylene, p-n-dodecylstylene, 2,4-dimethylstylene, 3,4-dichlorostylene, and divinylbenzene.

Examples of the (meth)acrylic-based resins include alkyl(meth)acrylate, (meth)acrylonitrile, (meth)acrylamide, (meth)acrylic acid, glycidyl(meth)acrylate, 2-hydroxyethylmethacrylate, 2-hydroxypropylmethacrylate, ethyleneglycol di (meth)acrylate, trimethylolpropane(meth)acrylate, and dipentaerythritol(meth)acrylate. Examples of the alkyl(meth)acrylate include methyl (meth) acrylate, ethyl (meth) acrylate, propyl(meth)acrylate, butyl (meth) acrylate, cumyl (meth) acrylate, cyclohexyl(meth)acrylate, myristyl(meth)acrylate, palmityl(meth)acrylate, stearyl (meth) acrylate, and isobornyl (meth)acrylate.

The thickness of the coating layer is preferably in a range of 10 nm to 1 μm. The coating layer having a thickness of not less than 10 nm can sufficiently achieve the effect of enhancing the dispersibility of the coated body (X2) in the resin and the effect of improving the resistance to moist heat of a cured product of the die bonding material. The coating layer having a thickness of not more than 1 μm further increases the thermal conductivity of the coated body (X2).

Shape of the substance (X) is not particularly limited. The substance (X) preferably has a substantially polyhedral shape, or a shape with an aspect ratio, i.e., ratio of the longer diameter to the shorter diameter, of 1 to 2. In this case, a high density of the substance (X) can be filled in the die bonding material, and thus a cured product of the die bonding material can have an enhanced heat radiation property.

The substance (X) is preferably at least one of a substance (Xx1) of spherical anhydrous magnesium carbonate (X1x1) represented by chemical formula $MgCO_3$ not containing crystal water, and a coated body (X2x1) including the spherical anhydrous magnesium carbonate (X1x1) and an organic resin, a silicone resin, or silica coated on the surface

thereof. Meanwhile, the coated body (X2x1) can be formed into a spherical shape by coating the spherical anhydrous magnesium carbonate (X1x1) with an organic resin, a silicone resin, or silica. Moreover, the substance (Xx1) preferably has a spherical shape. In the case of a spherical shape, a high density of the substance (Xx1) can be filled in the die bonding material, and thus a cured product of the die bonding material can have an enhanced heat radiation property. Furthermore, a cured product of the die bonding material can have high dielectric breakdown property.

The spherical shape is not particularly limited to a sphere. The spherical shape includes a sphere with slightly flattened portions or distorted portions. For example, the spherical shape includes a shape with an aspect ratio of 1 to 1.5, or a shape in which much of the surface, e.g. at least 30% of the surface, is covered not by a flat surface or the like but by a curved surface, and a part of the surface, e.g. less than 70% of the surface, is covered not by a flat surface or the like but by a flat surface. A shape with at least 50% of its surface covered by a curved surface is more preferable, and a shape with at least 70% of its surface covered by a curved surface is further preferable.

The spherical anhydrous magnesium carbonate (X1x1) , the coated body (X2x1) including the spherical anhydrous magnesium carbonate, or the spherical substance (Xx1) is preferably a product spheroidized by a jet mill or a pulverization and surface treatment apparatus having a rotatable rotor and stator. The spheroidizing processing can enhance the sphericity, and a spherical shape or an almost spherical shape can be achieved. Moreover, the spheroidizing processing can pulverize an aggregate of the substance (X) as well. Accordingly, the substance (Xx1) can be filled at a high density in the die bonding material. As a result, a cured product of the die bonding material can have further enhanced heat radiation property. Furthermore, a cured product of the die bonding material can have further enhanced dielectric breakdown property.

The average particle diameter of the substance (X) is preferably in a range of 0.01 μm to 40 μm. The average particle diameter of the substance (X) is more preferably not less than 0.1 μm, and is more preferably not more than 10 μm, and further preferably not more than 3 μm. The average particle diameter of not less than the minimum value makes it easier to charge the substance (X) at a high density. The average particle diameter of not more than the maximum value prevents the die bonding material from having too large thickness in an optical semiconductor device, and a cured product of the die bonding material can have further enhanced dielectric breakdown property.

The average particle diameter of the substance (X) is particularly preferably not more than 3 μm. In this case, the substance (X) is far less likely to deposit in the die bonding material, and thus the die bonding material is far less likely to crack.

The "average particle diameter" used herein refers to an average particle diameter determined from the measurement result of a particle diameter distribution of volume-weighted mean diameter measured using a laser diffraction particle diameter distribution analyzer.

In order to enhance the heat radiation property of a cured product of the die-bonding material by forming a close filled structure in the die bonding material, two or more kinds of the substance (X) with different shapes may be used. Alternatively, two or more kinds of the substance (X) with different particle diameters may be used.

The substance (X) is also preferably at least one substance (Xx2) among substantially polyhedral anhydrous magnesium carbonate (X1x2) represented by chemical formula $MgCO_3$ not containing crystal water, and a coated body (X2x2) including the anhydrous magnesium carbonate (X1x2) and an organic resin, a silicone resin, or silica coated on the surface thereof. Meanwhile, by coating the surface of the substantially polyhedral anhydrous magnesium carbonate (X1x2) with an organic resin, a silicone resin, or silica, the coated body (X2x2) can be formed into a substantially polyhedral shape. The substance (Xx2) preferably has a spherical shape. In the case where the substance (Xx2) has a substantially polyhedral shape, preferably a filler (Y) is further included other than the substance (X). The filler (Y) is preferably a plate filler.

In the case where the substance (Xx2) has a substantially polyhedral shape, and a plate filler is included, the substance (Xx2) makes a face contact, not a point contact, with the plate filler in the die bonding material. Thereby, the contact area between the substance (Xx2) and the plate filler is increased. Moreover, a plurality of the substance (Xx2) dispersed with a distance from one another in the die bonding material are allowed to contact to, or come close to each other via the plate filler. As a result, the fillers form a crosslinked structure or a structure in which they are effectively adjacent one another. Accordingly, a cured product of the die bonding material can have higher thermal conductivity.

The "substantially polyhedral shape" refers to not only a generally-defined polyhedral shape formed only of plane surfaces, but also a shape formed of plane shapes and a certain rate or less of curved surfaces. Examples of the polyhedral shape include a shape formed of 10% or less of curved surface and 90% or more of flat surfaces. Preferably, the substantially polyhedral shape is a substantially cubic shape or a substantially rectangular parallelpiped shape.

The amount of the substance (X) in 100 wt% of the die bonding material is preferably in a range of 20 wt% to 90 wt%. The amount of the substance (X) in 100 wt% of the die bonding material is more preferably not less than 30 wt%, and is more preferably not more than 80 wt%. The amount of the substance (X) of not less than the minimum value can further enhance the heat radiation property of a cured product of the die bonding material. The amount of the substance (X) of not more than the maximum value can further enhance the flexibility and the adhesion property of the die bonding material.

In the case where the filler (Y), which is to be described below, is not contained, the amount of the substance (X) in 100 wt% of the die bonding material is more preferably in a range of 30 wt% to 90 wt%.

(Filler (Y))

The die bonding material for an optical semiconductor device according to the present invention may include a filler (Y) which is different from the substance (X), in addition to the substance (X). Use of the filler (Y) can further increase the thermal conductivity of a cured product of the die bonding material. The filler (Y) may be used alone, or two or more kinds thereof may be used in combination.

The filler (Y) may be an inorganic filler or an organic filler. The filler (Y) is preferably an inorganic filler.

The filler (Y) is not particularly limited. In terms of far more enhancing the heat radiation property of a cured product of the die bonding material, the filler is preferably one selected from the group consisting of alumina(aluminum oxide), silica, boron nitride, aluminum nitride, silicon nitride, carbon nitride, silicon carbide, zinc oxide, magnesium oxide, talc, mica, and hydrotalcite. In terms of further increasing the thermal conductivity and further enhancing the heat radiation property of a cured product of the die bonding material, the filler (Y) is particularly preferably at least one selected from the group consisting of aluminum oxide, boron nitride, silicon nitride, and zinc oxide.

In terms of further increasing the thermal conductivity of the die bonding material, the thermal conductivity of the filler (Y) is preferably not less than 10 W/m·K. The thermal conductivity of the filler (Y) is more preferably not less than 15 W/m·K, and further preferably not less than 20 W/m·K. The maximum value of the thermal conductivity of the filler (Y) is not particularly limited. Inorganic fillers having a thermal conductivity of about 300 W/m·K are widely known, and inorganic fillers having a thermal conductivity of about 200 W/m·K are easily available.

The filler (Y) preferably has a spherical shape. In the case of a spherical shape, the filler (Y) can be filled at a high density. As a result, the heat radiation property of a cured product of the die bonding material can be further enhanced.

The average particle diameter of the filler (Y) is preferably in a range of 0. 01 μm to 40 μm. The average particle diameter of the filler (Y) is more preferably not less than 0.01 μm, and is more preferably not more than 10 μm, and further preferably not more than 2 μm. The average particle diameter of not less than the minimum value leads to easy filling of the filler (Y) at a high density. The average particle diameter of not more than the maximum value can further enhance the dielectric breakdown property of a cured product of the die bonding material.

The average particle diameter of the filler (Y) is particularly preferably in a range of 0.01 μm to 2 μm. In this case, the filler (Y) is far less likely to deposit in the die bonding material, and thus the die bonding material is far less likely to crack.

The "average particle diameter" used herein refers to an average particle diameter determined from the measurement result of a particle diameter distribution of volume-weighted mean diameter measured using a laser diffraction particle diameter distribution analyzer.

In the case where the substance (Xx2) is included, the filler (Y) is preferably a plate filler.

The average particle diameter of the substance (Xx2) is preferably in a range of 0.01 μm to 40 μm. The average longer diameter of the plate filler is preferably in a range of 0.01 μm to 10 μm. Use of the substance (Xx2) and the plate filler each having the aforementioned shape can allow the substance (Xx2) to fully make contact with the plate filler in the die bonding material. As a result, the thermal conductivity of a cured product of the die bonding material can be further increased.

In the case where the average longer diameter of the plate filler is less than 0.01 μm, filling of the plate filler may be difficult, or crosslinking with the plate filler among the substantially polyhedral substance (Xx2) may not be efficient and sufficient. In the case where the average longer diameter of the plate filler exceeds 10 μm, the die bonding material tends to have low insulating properties. The average longer diameter of the plate filler is more preferably in a range of 0.5 μm to 9 μm, and further preferably in a range of 1 μm to 9 μm.

The average thickness of the plate filler is preferably not less than 100 nm. The plate filler having a thickness of not less than 100 nm can further increase the thermal conductivity of the cured product. The aspect ratio of the plate filler is preferably in a range of 2 to 50. In the case where the aspect ratio of the plate filler exceeds 50, filling of the plate filler may be difficult. The plate filler preferably has an aspect ratio in a range of 3 to 45.

The plate filler is preferably at least one of alumina and boron nitride. In this case, the thermal conductivity of a cured material of the die bonding material can be further increased. In especially the case where the substance (Xx2) and at least one of alumina and boron nitride are used in combination, the thermal conductivity of a cured product of the die bonding material can be furthermore increased.

In the case of using the substance (X) and the filler (Y) in combination, the amounts of the substance (X) and the filler (Y) are appropriately determined such that the amounts are optimal depending the kinds, particle diameters, and shapes of the substance (X) and the filler (Y). Total amount of the substance (X) and an inorganic filler (Y) in 100 wt% of the die bonding material is preferably in a range of 60 wt% to 90 wt%. The total amount of the substance (X) and the inorganic filler (Y) of not less than 60 wt% can further enhance the heat radiation property of the cured product. The

total amount of the substance (X) and the inorganic filler (Y) of not more than 90 wt% further enhances the flexibility or the adhesion property of the die bonding material.

In the case of using the substance (X) and the filler (Y) in combination, the substance (X) content in 100 wt% of the total amounts of the substance (X) and the filler (Y) is preferably not less than 0.1 wt%, more preferably not less than 1 wt%, particularly preferably not less than 10 wt%, and most preferably not less than 30 wt%. In the case of using the substance (X) and the filler (Y) in combination, the substance (X) content in 100 wt% of the die bonding material is more preferably in a range of 20 wt% to 80 wt%.

Preferably, a volume ratio of the substance (Xx2) and the plate filler contained in the die bonding material is 70:30 to 99:1. A total amount of the substance (Xx2) and the plate filler in 100 wt% of the die bonding material is preferably in a range of 60 wt% to 90 wt%. More preferably, a volume ratio of the substance (Xx2) and the plate filler contained in the die bonding material is 70:30 to 99:1, and also a total amount of the substance (Xx2) and the plate filler in 100 wt% of the die bonding material is in a range of 60 wt% to 90 wt%. In the case where the amounts of the substance (X2x) and the plate filler are each in the above preferable range, the thermal conductivity of a cured product of the die bonding material can be further increased.

(Coupling agent)

The die bonding material for an optical semiconductor device according to the present invention may further include a coupling agent to provide adhesiveness.

The coupling agent is not particularly limited, and may be silane coupling agents or the like. Examples of the silane coupling agents include vinyltriethoxysilane, vinyltrimethoxysilane, 3-glycidoxypropyltrimethoxysilane, 2-(3,4-epoxycyclohexyl)ethyltrimethoxysilane, γ-methacryloxypropyltrimethoxysilane, γ-aminopropyltrimethoxysilane, and N-phenyl-3-aminopropyltrimethoxysilane. The coupling agent may be used alone or in combination of two or more kinds thereof.

(Other components)

The die bonding material for an optical semiconductor device according to the present invention may contain, if necessary, ultraviolet ray absorbers, antioxidants, solvents, colorants, fillers, defoamers, surface-processing agents, flame retardants, viscosity-controlling agents, viscosity modifier, dispersants, dispersion aids, surface modifiers, plasticizers, leveling agents, stabilizers, coupling agents, anti-sagging agents, phosphors, or the like.

(Details and applications of the die bonding material for optical semiconductor device)

The die bonding material for an optical semiconductor device of the present invention may be a paste, or a film. The die bonding material is preferably a paste. If the die bonding material is a paste, the substance (X) still tends not to deposit, and thus can maintain favorable dispersion condition.

Solutions respectively containing one kind or two or more kinds of the first silicone resin, the second silicone resin, and the catalyst for hydrosilylation reaction may be separately prepared, and the die bonding material for an optical semiconductor device may be prepared by mixing a plurality of the solutions immediately before use. For example, the die bonding material for an optical semiconductor device according to the present invention may be prepared by separately preparing a solution A containing the second silicone resin and the catalyst for hydrosilylation reaction and a solution B containing the first silicone resin, and mixing the solution A and the solution B immediately before use. In this case, the substance (X) and the filler (Y) each may be contained in the solution A or may be contained in the solution B. In this manner, by preparing two solution separately as a first solution containing the second silicone resin and the catalyst for hydrosilylation reaction and a second solution containing the first silicone resin, the storage stability can be enhanced.

The production method of the die bonding material for an optical semiconductor device according to the present invention is not particularly limited. Examples of the production method include a method in which the first silicone resin, the second silicone resin, the catalyst for hydrosilylation reaction, the substance (X) , and optional other components are mixed by a mixer such as a homodisper, a homomixer, a versatile mixer, a planetarium mixer, a kneader, a three-roll mill, and a beads mill at normal temperature or under heating.

An optical semiconductor device can be produced by placing the die bonding material for an optical semiconductor device according to the present invention on a member to be connected such as a substrate, or disposing at a lower side of the optical semiconductor element, and then connecting the member to be connected and the optical semiconductor element via the die bonding material.

The curing temperature of the die bonding material for an optical semiconductor device according to the present invention is not particularly limited. The curing temperature of the die bonding material for an optical semiconductor device is preferably not lower than 80°C, more preferably not lower than 100°C, and is preferably not higher than 180°C,

more preferably not higher than 150°C. The curing temperature of not lower than the lowest temperature allows curing of the die bonding material to sufficiently proceed. The curing temperature of not higher than the highest temperature tends not to cause thermal degradation of the die bonding material and the member to be connected by the die bonding material.

The curing method is not particularly limited but is preferably a step-cure method. The step-cure method is a method including temporary curing at a low temperature and subsequent substantial curing at a high temperature. The step-cure method can prevent shrinkage on curing of the die bonding material.

(Optical semiconductor device)

The optical semiconductor device according to the present invention is provided with a die bonding material for an optical semiconductor device, a member to be connected, and an optical semiconductor element connected to the member to be connected using the die bonding material for an optical semiconductor device.

Specific examples of the optical semiconductor device according to the present invention include a light-emitting diode device, a semiconductor laser device, and a photo coupler. The optical semiconductor device of this kind may favorably be used as backlight for a liquid crystal display or the like, lightings, various sensors, light source for printers, photocopiers or the like, light source for vehicle gauze, signal lights, display lights, display devices, light source for sheet radiator, displays, decorations, various lights, and switching elements.

The light-emitting devices as the optical semiconductor element is not particularly limited as long as the light-emitting element includes a semiconductor. For example, in the case where the light-emitting element is light-emitting diode, examples thereof include a structure in which a semiconductor material for LED style is layered on a substrate. Examples of the semiconductor material in this example include GaAs, GaP, GaAlAs, GaAsP, AlGaInP, GaN, InN, AlN, InGaAlN, and SiC.

Examples of the material for the substrate includes single crystals of sapphire, spinel, SiC, Si, ZnO, and GaN. A buffer layer may be formed between the substrate and the semiconductor material, if necessary. Examples of the material for the buffer layer include GaN and A1N.

Fig. 1 shows a front cross-sectional view of an optical semiconductor device according to a first embodiment of the present invention.

An optical semiconductor device 1 of the present embodiment includes a housing 2 as a member to be connected, and an optical semiconductor element 3. The optical semiconductor element 3 formed of an LED is provided in the housing 2. The optical semiconductor element 3 is surrounded by an inner face 2a having the light-reflective property of the housing 2. According to the present embodiment, the optical semiconductor element 3 is used as a light-emitting element formed of an optical semiconductor.

The inner face 2a is formed such that the diameter of the inner face 2a increases towards an opening end. For this reason, a portion of light emitted from the optical semiconductor element 3 and arriving at the inner face 2a is reflected on the inner face 2a and travels to a front side of the optical semiconductor element 3.

The optical semiconductor element 3 is connected to a lead electrode 4 mounted on the housing 2 using a die bonding material 5. The die bonding material 5 is a die bonding material for an optical semiconductor device. A bonding pad (not shown) provided on the optical semiconductor element 3 is electrically connected to the lead electrode 4 via a bonding wire 6. A sealant 7 is filled in an area surrounded by the inner surface 2a to seal the optical semiconductor element 3 and the bonding wire 6.

The die boning material 5 may be disposed in a manner that the die bonding material 5 sticks out of the bottom of the optical semiconductor element 3 and covers the surrounding thereof, or may be disposed at the bottom of the optical semiconductor element 3 without sticking out. The thickness of the die bonding material 5 is preferably in a range of 2 μm to 50 μm.

In the optical semiconductor device 1, activation of the optical semiconductor element 3 causes emission of light as shown by dashed lines A. In this case, light emitted from the optical semiconductor element 3 is not only irradiated to the opposite side of the upper surface of the lead electrode 4, namely, to the upper direction, but also arrives and is reflected on the die bonding material 5 in a manner as shown by lines B2.

The structure shown in Fig. 1 is mere an example of the optical semiconductor device according to the present invention. The implementation structure and the like of the optical semiconductor element 3 may be appropriately modified.

Hereinafter, the present invention will be described in more detail with reference to examples. The present invention is not limited to the examples.

(Synthesis Example 1) Synthesis of first silicone resin

Dimethyldimethoxysilane (120 g), methyltrimethoxysilane (54 g), and 1,1,3,3-tetramethyldisiloxane (40 g) were charged into a 1000-mL separable flask equipped with a thermometer, a dropping appliance, and a stirrer, and were

stirred at 50°C. An aqueous solution of 1.2 g hydrochloric acid dissolved in 83 g of water was slowly dropwise added to the mixture, and then stirred for six hours at 50°C for reaction to give a reaction solution. Next, volatile components were evaporated in vacuo, and thereby a polymer was provided. To the polymer were added 150 g of hexane and 150 g of ethylacetate. The resulting mixture was washed 10 times with 300 g of ion-exchange water, and then volatile components were evaporated in vacuo. Thereby, a polymer (A) was provided.
The number average molecular weight (Mn) of the polymer (A) was 1500. Result of chemical structure identification using $^{29}$Si-NMR showed that the polymer (A) had a following average composition formula (A1).
Composition formula (A1):

$$(HMe_2SiO_{1/2})_{0.20} (Me_2SiO_{2/2})_{0\cdot50} (MeSiO_{3/2})_{0\cdot30}$$

In the formula (A1), Me refers to a methyl group.
The molecular weights of polymers obtained in respective synthesis examples 1 and 2 to 8 were determined by adding 1 mL of tetrahydrofuran to 10 mg of each polymer, stirring the mixture until dissolved, followed by GPC analysis. In the GPC analysis, a measuring apparatus produced by Waters (column: two columns, Shodex GPC LF-804 (length: 300 mm) produced by Showa Denko K.K, temperature: at 40°C, flow rate: 1 mL/min, solvent: tetrahydrofuran, Standard material: polystylene) was used.

(Synthesis Example 2) Synthesis of first silicone resin

Dimethyldimethoxysilane (48 g), methyltrimethoxysilane (163 g), and 1,1,3, 3-tetramethyldisiloxane (27 g) were charged into a 1000-mL separable flask equipped with a thermometer, a dropping appliance, and a stirrer, and were stirred at 50°C. An aqueous solution of 1.2 g hydrochloric acid dissolved in 102 g of water was slowly dropwise added to the mixture, and then stirred for six hours at 50°C for reaction to give a reaction solution. Next, volatile components were evaporated in vacuo, and thereby a polymer was provided. To the polymer were added 150 g of hexane and 150 g of ethylacetate. The resulting mixture was washed 10 times with 300 g of ion-exchange water, and then volatile components were evaporated in vacuo. Thereby, a polymer (B) was provided.
The number average molecular weight (Mn) of the polymer (B) was 1500. Result of chemical structure identification using $^{29}$Si-NMR showed that the polymer (B) had a following average composition formula (B1).
Composition formula (B1):

$$(HMe2SiO_{1/2})_{0.20} (Me_2SiO_{2/2})_{0.30} (MeSiO_{3/2})_{0\cdot50}$$

In the formula (B1), Me refers to a methyl group.

(Synthesis Example 3) Synthesis of first silicone resin

Dimethyldimethoxysilane (48 g), vinylmethyldimethoxysilane (26 g), phenyltrimethoxysilane (119 g), methyltrimethoxysilane (54 g), and 1,1,3,3-tetramethyldisiloxane (27 g) were charged into a 1000-mL separable flask equipped with a thermometer, a dropping appliance, and a stirrer, and were stirred at 50°C. An aqueous solution of 1.2 g hydrochloric acid dissolved in 101 g of water was slowly dropwise added to the mixture, and then stirred for six hours at 50°C for reaction to give a reaction solution. Next, volatile components were evaporated in vacuo, and thereby a polymer was provided. To the polymer were added 150 g of hexane and 150 g of ethylacetate. The resulting mixture was washed 10 times with 300 g of ion-exchange water, and then volatile components were evaporated in vacuo. Thereby, a polymer (C) was provided.
The number average molecular weight (Mn) of the polymer (C) was 1300. Result of chemical structure identification using $^{29}$Si-NMR showed that the polymer (C) had a following average composition formula (C1).
Composition formula (C1):

$$(HMe_2SiO_{1/2})_{0.20} (Me_2SiO_{2/2})\ 0.20\ (ViMeSiO_{2/2})_{0.10} (MeSiO_{3/2})_{0\cdot20} (P\ hSiO_{3/2})_{0\cdot30}$$

In the formula (C1) , Me refers to a methyl group, Ph refers to a phenyl group, and Vi refers to a vinyl group. The phenyl group content in the polymer (C) was 18 mol%.
(Synthesis Example 4) Synthesis of first silicone resin
Dimethyldimethoxysilane (26 g), phenyltrimethoxysilane (119 g), methyltrimethoxysilane (54 g), 1,4-bis(dimethylmethoxysilyl)benzene (40 g), and 1,1,3,3-tetramethyldlsiloxane (27 g) were charged into a 1000-mL separable flask equipped with a thermometer, a dropping appliance, and a stirrer, and were stirred at 50°C. An aqueous solution of 1.4 g hydrochloric acid dissolved in 99 g of water was slowly dropwise added to the mixture, and then stirred for six hours at 50°C for

reaction to give a reaction solution. Next, volatile components were evaporated in vacuo, and thereby a polymer was provided. To the polymer were added 150 g of hexane and 150 g of ethylacetate. The resulting mixture was washed 10 times with 300 g of ion-exchange water, and then volatile components were evaporated in vacuo. Thereby, a polymer (D) was provided.

The number average molecular weight (Mn) of the polymer (D) was 1200. Result of chemical structure identification using $^{29}$Si-NMR showed that the polymer (D) had a following average composition formula (D1).

Composition formula (D1):

$$(HMe_2SiO_{1/2})_{0.20}(Me_2SiO_{2/2})_{0.20}(MeSiO_{3/2})_{0.20}(PhSiO_{3/2})_{0.30}(Me4\ SiPheO_{2/2})_{0.10}$$

In the formula (D1), Me refers to a methyl group, Ph refers to a phenyl group, and Phe refers to a phenylene group.

A content of the phenyl group and the phenylene group (aryl group content) in the polymer (D) was 26 mol%.

(Synthesis Example 5) Synthesis of first silicone resin

Vinylmethyldimethoxysilane (26 g), phenyltrimethoxysilane (119g), methyltrimethoxysilane (54g), 1,4-bis (dimethylmethoxysilyl)benzene (40 g), and 1,1,3,3-tetramethyldisiloxane (27 g) were charged into a 1000-mL separable flask equipped with a thermometer, a dropping appliance, and a stirrer, and were stirred at 50°C. An aqueous solution of 0. 8 g potassium hydroxide dissolved in 114 g of water was slowly dropwise added to the mixture, and then stirred for six hours at 50°C for reaction to give a reaction solution. Next, 0.9 g of acetic acid was added to the reaction solution, and volatile components were evaporated in vacuo. Potassium acetate was removed by filtration to give a polymer (E).

The number average molecular weight (Mn) of the polymer (E) was 1000. Result of chemical structure identification using $^{29}$Si-NMR showed that the polymer (E) had a following average composition formula (E1).

Composition formula (E1):

$$(HMe_2SiO_{1/2})_{0\cdot20}(ViMeSiO_{2/2})_{0\cdot10}(MeSiO_{3/2})_{0\cdot30}(PhSiO_{3/2})_{0\cdot30}(M\ e_4SiPheO_{2/2})_{0\cdot10}$$

In the formula (E1), Me refers to a methyl group, Ph refers to a phenyl group, Vi refers to a vinyl group, and Phe refers to a phenylene group.

A content of the phenyl group and the phenylene group (aryl group content) in the polymer (E) was 31 mol%.

(Synthesis Example 6) Synthesis of second silicone resin

Trimethylmethoxysilane (41 g), dimethyldimethoxysilane (72 g), methyltrimethoxysilane (81 g), and vinylmethyldimethoxysilane (52 g) were charged into a 1000-mL separable flask equipped with a thermometer, a dropping appliance, and a stirrer, and were stirred at 50°C. An aqueous solution of 0.8 g potassium hydroxide dissolved in 114 g of water was slowly dropwise added to the mixture, and then stirred for six hours at 50°C for reaction to give a reaction solution. Next, 0.9 g of acetic acid was added to the reaction solution, and volatile components were evaporated in vacuo. Potassium acetate was removed by filtration to give a polymer (F).

The number average molecular weight (Mn) of the polymer (F) was 2000. Result of chemical structure identification using $^{29}$Si-NMR showed that the polymer (F) had a following average composition formula (F1).

Composition formula (F1):

$$(Me_3SiO_{1/2})_{0.20}(ViMeSiO_{2/2})_{0\cdot20}(Me_2SiO_{2/2})_{0\cdot30}(MeSiO_{3/2})_{0\cdot30}$$

In the formula (F1), Me refers to a methyl group, and Vi refers to a vinyl group.

(Synthesis Example 7) Synthesis of second silicone resin

Trimethylmethoxysilane (41 g), vinylmethyldimethoxysilane (52 g), methyltrimethoxysilane (54 g), and phenyltrimethoxysilane (158 g) were charged and stirred at 50°C. An aqueous solution of 0.8 g potassium hydroxide dissolved in 114 g of water was slowly dropwise added to the mixture, and then stirred for six hours at 50°C for reaction to give a reaction solution. Next, 0.9 g of acetic acid was added to the reaction solution, and volatile components were evaporated in vacuo. Potassium acetate was removed by filtration to give a polymer (G).

The number average molecular weight (Mn) of the polymer (G) was 2000. Result of chemical structure identification using $^{29}$Si-NMR showed that the polymer (G) had a following average composition formula (G1).

Composition formula (G1):

$(Me_3SiO_{1/2})_{0\cdot 20}$ $(ViMeSiO_{2/2})_{0\cdot 20}$ $(MesiO_{3/2})_{0\cdot 20}$ $(PhSiO_{3/2})_{0\cdot 40}$

In the formula (G1), Me refers to a methyl group, Ph refers to a phenyl group, and Vi refers to a vinyl group.

The phenyl group content in the polymer (G) was 14 mol%.

(Synthesis Example 8) Synthesis of second silicone resin

Trimethylmethoxysilane (41 g), vinylmethyldimethoxysilane (52 g), methyltrimethoxysilane (54 g), phenyltrimethoxysilane (119 g), and 1, 4-bis (dimethylmethoxysilyl)benzene (40 g) were charged into a 1000-mL separable flask equipped with a thermometer, a dropping appliance, and a stirrer, and were stirred at 50°C. An aqueous solution of 0.8 g potassium hydroxide dissolved in 114 g of water was slowly dropwise added to the mixture, and then stirred for six hours at 50°C for reaction to give a reaction solution. Next, 0.9 g of acetic acid was added to the reaction solution, and volatile components were evaporated in vacuo. Potassium acetate was removed by filtration to give a polymer (H).

The number average molecular weight (Mn) of the polymer (H) was 1500. Result of chemical structure identification using $^{29}$Si-NMR showed that the polymer (H) had a following average composition formula (H1).

Composition formula (H1):

$(Me_3SiO_{1/2})_{0\cdot 20}$ $(ViMeSiO_{2/2})_{0\cdot 20}$ $(MeSiO_{3/2})_{0\cdot 20}$ $(PhSiO_{3/2})_{0\cdot 30}$ $(Me_4\ SiPheO_{2/2})_{0.10}$

In the formula (H1), Me refers to a methyl group, Ph refers to a phenyl group Vi refers to a vinyl group, and Phe refers to a phenylene group.

A content of the phenyl group and the phenylene group (aryl group content) in the polymer (H) was 16 mol%.

(Synthesis Example 9) Production of coated body (X2)

Methylisobutylketone (1000 g) as a dispersion medium, a synthesized magnesite (600 g) in a substantially polyhedral shape (produced by Konoshima Chemical Co. , Ltd, trade name: MSL, average particle diameter: 6 μm), dipentaerythritol hexamethacrylate (50 g), andazobisisobutylonitrile (1g) were charged into a 2L-container equipped with a stirrer, a jacket, a reflux condenser, and a thermometer, and then mixed by stirring to give a dispersion liquid containing a surface treatment solution and magnesite dispersed in the solution. After deoxidization by reducing the pressure in the container, the inner pressure was returned to the atmospheric pressure with nitrogen such that inside of the container was in a nitrogen atmosphere. Next, the temperature inside the container was raised by heating to 70°C while stirring to carry out reaction for eight hours, and then cooled to room temperature. The solvent in the reaction solution was removed by centrifugal filtration, followed by drying in vacuo. Thereby, a synthesized magnesite (6 μm) which was coated with a methacrylic resin on its surface (acrylic resin-coated synthesized magnesite (6 μm)) was obtained.

(Synthesis Example 10) Production of coated body (X2)

A synthesized magnesite (6 μm) which was coated with a silicone resin on its surface (silicone resin-coated synthesized magnesite (6 μm)) was obtained in the same manner as in synthesis example 9, except that a silicone containing methacryloxy groups on both terminals (produced by Chisso Corp., trade name: Silaplane FM-7721) was used instead of the dipentaerythritol hexamethacrylate as a monomer to coat the surface.

(Synthesis Example 11) Production of coated body (X2)

Ion exchange water with a controlled pH of 9 (1000 g) as a dispersion medium, a synthesized magnesite (600 g) in a substantially polyhedral shape (produced by Konoshima Chemical Co., Ltd, trade name: MSL, average particle diameter: 6 μm), and tetraethoxysilane (60 g) were charged into a 2L-container equipped with a stirrer, a jacket, a reflux condenser, and a thermometer, and then mixed by stirring to give a dispersion liquid containing a surface treatment solution and magnesite dispersed in the solution. Next, the temperature inside the container was raised by heating to 70°C while stirring to carry out reaction for eight hours, and then cooled to room temperature. The water in the reaction solution was removed by centrifugal filtration, followed by drying in vacuo. Thereby, a synthesized magnesite (6 μm) which was coated with silica on its surface (silica-coated synthesized magnesite (6 μm)) was obtained.

(Synthesis Example 12) Production of coated body (X2)

A synthesized magnesite (1.2 μm) which was coated with a methacrylic resin on its surface (acrylic resin-coated synthesized magnesite (1.2 μm)) was obtained in the same manner as in synthesis example 9, except that a synthesized

magnesite in a substantially polyhedral shape (produced by Konoshima Chemical Co., Ltd, trade name: MSS, average particle diameter: 1.2 μm)) was used instead of the synthesized magnesite in a substantially polyhedral shape (produced by Konoshima Chemical Co., Ltd, trade name: MSL, average particle diameter: 6 μm).

(Synthesis Example 13) Production of coated body (X2)

A synthesized magnesite (1.2 μm) which was coated with a silicone resin on its surface (silicone resin-coated synthesized magnesite (1.2 μm)) was obtained in the same manner as in synthesis example 10, except that a synthesized magnesite in a substantially polyhedral shape (produced by Konoshima Chemical Co., Ltd, trade name: MSS, average particle diameter: 1.2 μm)) was used instead of the synthesized magnesite in a substantially polyhedral shape (produced by Konoshima Chemical Co., Ltd, trade name: MSL, average particle diameter: 6 μm).

(Synthesis Example 14) Production of coated body (X2)

A synthesized magnesite (1.2 μm) which was coated with silica on its surface (silica-coated synthesized magnesite (1.2 μm)) was obtained in the same manner as in synthesis example 11, except that a synthesized magnesite in a substantially polyhedral shape (produced by Konoshima Chemical Co., Ltd, trade name: MSS, average particle diameter: 1.2 μm)) was used instead of the synthesized magnesite in a substantially polyhedral shape (produced by Konoshima Chemical Co., Ltd, trade name: MSL, average particle diameter: 6 μm).

(Example 1)

The polymer A (5 parts by weight), the polymer F (5 parts by weight), a platinum 1,3-divinyl-1,1,3,3-tetramethyldisiloxane complex (0.02 parts by weight), and the synthesized magnesite in a substantially polyhedral shape (produced by Konoshima Chemical Co., Ltd, trade name: MSL, average particle diameter: 6 μm) (60 parts by weight) corresponding to the anhydrous magnesium carbonate (X1) were mixed and then defoamed so that a die bonding material for an optical semiconductor device was provided.

(Example 2)

A die bonding material was obtained in the same manner as in Example 1, except that the synthesized magnesite (6 μm) coated with a methacrylic resin on its surface (acrylic resin-coated synthesized magnesite (6 μm)) obtained in Synthesis example 9 was used instead of the magnesite (produced by Konoshima Chemical Co., Ltd, trade name: MSL, average particle diameter: 6 μm).

(Example 3)

A die bonding material was obtained in the same manner as in Example 1, except that the synthesized magnesite (6 μm) coated with a silicone resin on its surface (silicone resin-coated synthesized magnesite (6 μm)) obtained in Synthesis example 10 was used instead of the magnesite (produced by Konoshima Chemical Co., Ltd, trade name: MSL, average particle diameter: 6 μm).

(Example 4)

A die bonding material was obtained in the same manner as in Example 1, except that the synthesized magnesite (6 μm) coated with silica on its surface (silica-coated synthesized magnesite (6 μm)) obtained in Synthesis example 11 was used instead of the magnesite (produced by Konoshima Chemical Co., Ltd, trade name: MSL, average particle diameter: 6 μm) corresponding to the anhydrous magnesium carbonate (X1).

(Example 5)

A die bonding material was obtained in the same manner as in Example 1, except that the polymer B (5 parts by weight) was used instead of the polymer A (5 parts by weight), and the polymer G (5 parts by weight) was used instead of the polymer F (5 parts by weight).

(Example 6)

A die bonding material was obtained in the same manner as in Example 1, except that the polymer C (5 parts

by weight) was used instead of the polymer A (5 parts by weight), and the polymer G (5 parts by weight) was used instead of the polymer F (5 parts by weight).

(Example 7)

A die bonding material was obtained in the same manner as in Example 1, except that the polymer D (5 parts by weight) was used instead of the polymer A (5 parts by weight), and the polymer G (5 parts by weight) was used instead of the polymer F (5 parts by weight).

(Example 8)

A die bonding material was obtained in the same manner as in Example 1, except that the polymer E (5 parts by weight) was used instead of the polymer A (5 parts by weight), and the polymer G (5 parts by weight) was used instead of the polymer F (5 parts by weight).

(Example 9)

A die bonding material was obtained in the same manner as in Example 1, except that the polymer E (5 parts by weight) was used instead of the polymer A (5 parts by weight), and the polymer H (5 parts by weight) was used instead of the polymer F (5 parts by weight).

(Example 10)

A die bonding material was obtained in the same manner as in Example 1, except that the synthesized magnesite in a substantially polyhedral shape (produced by Konoshima Chemical Co., Ltd, trade name: MSS, average particle diameter: 1.2 μm) corresponding to the anhydrous magnesium carbonate (X1) was used instead of the synthesized magnesite (produced by Konoshima Chemical Co., Ltd, trade name: MSL, average particle diameter: 6 μm).

(Example 11)

A die bonding material was obtained in the same manner as in Example 1, except that the synthesized magnesite (1.2 μm) coated with a methacrylic resin on its surface (acrylic resin-coated synthesized magnesite (1.2 μm)) obtained in Synthesis example 12 was used instead of the magnesite (produced by Konoshima Chemical Co., Ltd, trade name: MSL, average particle diameter: 6 μm).

(Example 12)

A die bonding material was obtained in the same manner as in Example 1, except that the synthesized magnesite (1.2 μm) coated with a silicone resin on its surface (silicone resin-coated synthesized magnesite (1.2 μm)) obtained in Synthesis example 13 was used instead of the magnesite (produced by Konoshima Chemical Co., Ltd, trade name: MSL, average particle diameter: 6 μm).

(Example 13)

A die bonding material was obtained in the same manner as in Example 1, except that the synthesized magnesite (1.2 μm) coated with silica on its surface (silica-coated synthesized magnesite (1.2 μm)) obtained in Synthesis example 14 was used instead of the magnesite (produced by Konoshima Chemical Co., Ltd, trade name: MSL, average particle diameter: 1.2 μm).

(Example 14)

A die bonding material was obtained in the same manner as in Example 1, except that 10 parts by weight of aluminum nitride (produced by Tokuyama Corporation, average particle diameter: 0.6 μm, thermal conductivity: 100 W/m·K) corresponding to the filler (Y) was further mixed.

(Example 15)

A die bonding material was obtained in the same manner as in Example 1, except that 10 parts by weight of

boron nitride (produced by Mizushima Ferroalloy Co., Ltd., average particle diameter: 0.5 μm, thermal conductivity: 50 W/m·K) corresponding to the filler (Y) was further mixed.

(Example 16)

A die bonding material was obtained in the same manner as in Example 1, except that 10 parts by weight of silicon nitride (produced by Denki Kagaku Kogyo Kabushiki Kaisha, average particle diameter: 1.5 μm, thermal conductivity: 35 W/m·K) corresponding to the filler (Y) was further mixed.

(Example 17)

A die bonding material was obtained in the same manner as in Example 1, except that 10 parts by weight of zinc oxide (produced by Hakusuitech Ltd., average particle diameter: 0.2 μm, thermal conductivity: 25 W/m·K) corresponding to the filler (Y) was further mixed.

(Example 18)

A die bonding material was obtained in the same manner as in Example 1, except that 10 parts by weight of alumina (produced by Sumitomo Chemical Co. Ltd., average particle diameter: 0.4 μm, thermal conductivity: 20W/m·K) corresponding to the filler (Y) was further mixed.

(Comparative Example 1)

A die bonding material was obtained in the same manner as in Example 1, except that 60 parts by weight of magnesium oxide (produced by Sakai Chemical Industry Co., Ltd., average particle diameter: 1.1 μm, thermal conductivity: 30 W/m·K) was used instead of the synthesized magnesite (produced by Konoshima Chemical Co., Ltd, trade name: MSL, average particle diameter: 6 μm).

(Comparative Example 2)

A die bonding material was obtained in the same manner as in Example 1, except that 60 parts by weight of a crystal water-containing magnesium carbonate (produced by Konoshima Chemical Co., Ltd., average particle diameter: 9 μm, thermal conductivity: 15 W/m·K) was used instead of the synthesized magnesite (produced by Konoshima Chemical Co., Ltd, trade name: MSL, average particle diameter: 6 μm).

(Comparative Example 3)

A die bonding material was obtained in the same manner as in Example 1, except that 60 parts by weight of zinc oxide (produced by Hakusuitech Ltd., average particle diameter: 0.2 μm, thermal conductivity: 25 W/m·K) was used instead of the synthesized magnesite (produced by Konoshima Chemical Co., Ltd, trade name: MSL, average particle diameter: 6 μm).

(Comparative Example 4)

A die bonding material was obtained in the same manner as in Example 1, except that 60 parts by weight of alumina (produced by Sumitomo Chemical Co., Ltd., average particle diameter: 0.4 μm, thermal conductivity: 20 W/m·K) was used instead of the synthesized magnesite (produced by Konoshima Chemical Co., Ltd, trade name: MSL, average particle diameter: 6 μm).

(Comparative Example 5)

A die bonding material was obtained in the same manner as in Example 1, except that 60 parts by weight of silica (produced by Tokuyama Corporation, average particle diameter: 15 μm, thermal conductivity: 2 W/m·K) was used instead of the synthesized magnesite (produced by Konoshima Chemical Co. , Ltd, trade name: MSL, average particle diameter: 6 μm).

(Evaluation)

(1) Thermal conductivity

Each of the die bonding materials for an optical semiconductor device obtained in examples and comparative examples was heated at 150°C for three hours to be cured so that a cured product of the die bonding material in a shape of 100 mm × 100 mm×50μm in thickness was provided. The cured product was used as an evaluation sample.

The thermal conductivity of the thus obtained evaluation sample was measured using a thermal conductivity meter: trade name "Quick Thermal Conductivity Meter QTM-500" produced by Kyoto Electronics Manufacturing Co., Ltd. Meanwhile, a higher thermal conductivity is preferred, and the thermal conductivity needs to be at least 0.3 W/m·K.

(2) Dielectric breakdown voltage

The evaluation samples used in the evaluation of (1) Thermal di-conductivity were employed. Using an AC withstand voltage tester (Model 7473, produced by Extech Electronics), an AC voltage was applied between the cured products in a manner that the voltage increased at a rate of 1 kV/sec. The voltage that broke the cured product was determined as dielectric breakdown voltage.

(3) Gas barrier property (Water vapor transmission rate)

Each of the die bonding materials for an optical semiconductor device obtained in examples and comparative examples was heated at 150°C for three hours to be cured so that a cured product of the die bonding material in a shape of 100 mm×100 mm×1 mm in thickness was provided. The cured product was cut out in a circle shape having a diameter of 6 cm. Thereby evaluation samples were provided.

The evaluation sample was placed on a cup provided with calcium chloride as regulated by JIS Z0208, and the cup was sealed with a wax. After 24 hours standing in a relative humidity atmosphere of 85% at a temperature of 85°C, changes in the weight were measured. Thereby, the water vapor transmission rate ($g/m^2 \cdot 24h/100\ \mu m$) was determined.

(4) Adhesion property (Die shear strength)

The die bonding material for an optical semiconductor device was applied on an Ag-plated Cu substrate to give an adhesion area of 3 mm × 3 mm, and an 3 mm-square Si chip was mounted thereon. Thereby, a test sample was provided.

The thus obtained test sample was heated at a, temperature of 150°C for three hours to cure the die bonding material. Next, the die shear strength of the sample (before moisture absorption) at 185°C at a rate of 300 μ/sec was evaluated using a die shear tester (produced by Arctec Inc., Model No. DAGE 400D).

Further, the obtained test sample was allowed to stand in a high temperature/high humidity oven under a relative humidity atmosphere of 85% at a temperature of 85°C. Then, the die shear strength (after moisture absorption) at a temperature of 185°C was evaluated.

(5) Settleability test

Each of the die bonding materials for an optical semiconductor device obtained in examples and comparative examples was allowed to stand in a relative humidity of 50% at a temperature of 23°C for 100 hours. Thereafter, occurrence of deposition of the filler was examined by eye observation. The results were evaluated as follows: "o" in the case where no settlement was observed, and "x" in the case where settlement was observed.

(6) Reflow test

After the cured product was passed through a solder reflow furnace (preheated at 150°C × 100 seconds + reflow (maximum temperature: 260°C)) three times, occurrence of cracking in the cured product was examined by eye observation. The results were evaluated as follows: "×" in the case where the cured product cracked, and "o" in the case where the cured product did not crack.
Table 1 and Table 2 show the results.

[Table 1]

| | | | Example 1 | Example 2 | Example 3 | Example 4 | Example 5 | Example 6 | Example 7 | Example 8 | Example 9 | Example 10 | Example 11 | Example 12 | Example 13 |
|---|---|---|---|---|---|---|---|---|---|---|---|---|---|---|---|
| Component (parts by weight) | First silicone resin | Polymer A | 5 | 5 | 5 | 5 | | | | | | 5 | 5 | 5 | 5 |
| | First silicone resin | Polymer B | | | | | 5 | | | | | | | | |
| | First silicone resin | Polymer C | | | | | | 5 | | | | | | | |
| | First silicone resin | Polymer D | | | | | | | 5 | | | | | | |
| | First silicone resin | Polymer E | | | | | | | | 5 | 5 | | | | |
| | Second silicone resin | Polymer F | 5 | 5 | 5 | 5 | | | | | | 5 | 5 | 5 | 5 |
| | Second silicone resin | Polymer G | | | | | 5 | 5 | 5 | 5 | | | | | |
| | Second silicone resin | Polymer H | | | | | | | | | 5 | | | | |
| | Anhydrous magnesium carbonate (X1) | Magnesite 6 μm | 60 | | | | 60 | 60 | 60 | 60 | 60 | | | | |
| | Coated body (X2) | Acrylic resin-coated synthesized magnesite 6 μm | | 60 | | | | | | | | | | | |
| | Coated body (X2) | Silicone resin-coated synthesized magnesite 6 μm | | | 60 | | | | | | | | | | |
| | Coated body (X2) | Silica-coated synthesized magnesite 6 μm | | | | 60 | | | | | | | | | |
| | Anhydrous magnesium carbonate (X1) | Magnesite 1.2 μm | | | | | | | | | | 60 | | | |
| | Coated body (X2) | Acrylic resin-coated synthesized magnesite 1.2 μm | | | | | | | | | | | 60 | | |
| | Coated body (X2) | Silicone resin-coated synthesized magnesite 1.2 μm | | | | | | | | | | | | 60 | |
| | Coated body (X2) | Silica-coated synthesized magnesite 1.2 μm | | | | | | | | | | | | | 60 |
| | Filler (Y) | Magnesium oxide | | | | | | | | | | | | | |
| | Filler (Y) | Crystal water-containing magnesium carbonate | | | | | | | | | | | | | |
| | Filler (Y) | Aluminum nitride | | | | | | | | | | | | | |
| | Filler (Y) | Boron nitride | | | | | | | | | | | | | |
| | Filler (Y) | Silicon nitride | | | | | | | | | | | | | |
| | Filler (Y) | Zinc oxide | | | | | | | | | | | | | |
| | Filler (Y) | Alumina | | | | | | | | | | | | | |
| | Filler (Y) | Silica | | | | | | | | | | | | | |
| | Catalyst for hydrosilylation reaction | Platinum catalyst | 0.02 | 0.02 | 0.02 | 0.02 | 0.02 | 0.02 | 0.02 | 0.02 | 0.02 | 0.02 | 0.02 | 0.02 | 0.02 |
| Evaluation | Thermal conductivity | W/m·K | 1.19 | 1.18 | 1.14 | 1.19 | 1.2 | 1.19 | 1.17 | 1.19 | 1.16 | 1.18 | 1.24 | 1.27 | 1.24 |
| | Dielectric breakdown voltage | (kV/mm) | 25 | 27 | 28 | 29 | 25 | 24 | 24 | 25 | 25 | 51 | 61 | 59 | 58 |
| | Water vapor transmission rate | $g/m^2 \cdot 24h$ | 40 | 40 | 40 | 40 | 40 | 30 | 22 | 15 | 9 | 40 | 40 | 40 | 40 |
| | Die shear strength (before moisture absorption) | g | 1500 | 1500 | 1500 | 1500 | 1700 | 1800 | 1900 | 2000 | 2300 | 1500 | 1500 | 1500 | 1500 |
| | Die shear strength (after moisture absorption) | g | 1500 | 1500 | 1500 | 1500 | 1700 | 1800 | 1900 | 2000 | 2300 | 1500 | 1500 | 1500 | 1500 |
| | Settleability test | | ○ | ○ | ○ | ○ | ○ | ○ | ○ | ○ | ○ | ○ | ○ | ○ | ○ |
| | Reflow test (occurrence of cracking) | | ○ | ○ | ○ | ○ | ○ | ○ | ○ | ○ | ○ | ○ | ○ | ○ | ○ |

[Table 2]

| | | | Example 14 | Example 15 | Example 16 | Example 17 | Example 18 | Comparative Example 1 | Comparative Example 2 | Comparative Example 3 | Comparative Example 4 | Comparative Example 5 |
|---|---|---|---|---|---|---|---|---|---|---|---|---|
| Component (parts by weight) | First silicone resin | Polymer A | 5 | 5 | 5 | 5 | 5 | 5 | 5 | 5 | 5 | 5 |
| | First silicone resin | Polymer B | | | | | | | | | | |
| | First silicone resin | Polymer C | | | | | | | | | | |
| | First silicone resin | Polymer D | | | | | | | | | | |
| | First silicone resin | Polymer E | | | | | | | | | | |
| | Second silicone resin | Polymer F | 5 | 5 | 5 | 5 | 5 | 5 | 5 | 5 | 5 | 5 |
| | Second silicone resin | Polymer G | | | | | | | | | | |
| | Second silicone resin | Polymer H | | | | | | | | | | |
| | Anhydrous magnesium carbonate (X1) | Magnesite 6 µm | | | | | | | | | | |
| | Coated body (X2) | Acrylic resin-coated synthesized magnesite 6 µm | | | | | | | | | | |
| | Coated body (X2) | Silicone resin-coated synthesized magnesite 6 µm | | | | | | | | | | |
| | Coated body (X2) | Silica-coated synthesized magnesite 6 µm | | | | | | | | | | |
| | Anhydrous magnesium carbonate (X1) | Magnesite 1.2 µm | 60 | 60 | 60 | 60 | 60 | | | | | |
| | Coated body (X2) | Acrylic resin-coated synthesized magnesite 1.2 µm | | | | | | | | | | |
| | Coated body (X2) | Silicone resin-coated synthesized magnesite 1.2 µm | | | | | | | | | | |
| | Coated body (X2) | Silica-coated synthesized magnesite 1.2 µm | | | | | | | | | | |
| | Filler (Y) | Magnesium oxide | | | | | | 60 | | | | |
| | Filler (Y) | Crystal water-containing magnesium carbonate | | | | | | | 60 | | | |
| | Filler (Y) | Aluminum nitride | 10 | | | | | | | | | |
| | Filler (Y) | Boron nitride | | 10 | | | | | | | | |
| | Filler (Y) | Silicon nitride | | | 10 | | | | | | | |
| | Filler (Y) | Zinc oxide | | | | 10 | | | | 60 | | |
| | Filler (Y) | Alumina | | | | | 10 | | | | 60 | |
| | Filler (Y) | Silica | | | | | | | | | | 60 |
| | Catalyst for hydrosilylation reaction | Platinum catalyst | 0.02 | 0.02 | 0.02 | 0.02 | 0.02 | 0.02 | 0.02 | 0.02 | 0.02 | 0.02 |
| Evaluation | Thermal conductivity | W/m·K | 1.67 | 1.61 | 1.64 | 1.58 | 1.61 | 1.21 | 1.23 | 1.25 | 1.24 | 0.2 |
| | Dielectric breakdown voltage | (kV/mm) | 51 | 52 | 55 | 41 | 45 | 24 | 25 | 28 | 27 | 25 |
| | Water vapor transmission rate | g/m²·24h | 30 | 30 | 31 | 27 | 30 | 40 | 40 | 40 | 40 | 40 |
| | Die shear strength (before moisture absorption) | g | 1700 | 1700 | 1700 | 1700 | 1700 | 1500 | 1500 | 1500 | 1500 | 1500 |
| | Die shear strength (after moisture absorption) | g | 1700 | 1700 | 1700 | 1700 | 1700 | 200 | 200 | 1500 | 1500 | 1500 |
| | Settleability test | | ○ | ○ | ○ | ○ | ○ | ○ | ○ | × | × | ○ |
| | Reflow test (occurrence of cracking) | | ○ | ○ | ○ | ○ | ○ | × | ○ | ○ | × | ○ |

EXPLANATION OF SYMBOLS

1 Optical semiconductor device
2 Housing

2a Inner face
3 Optical semiconductor element
4 Lead electrode
5 Die bonding material
6 Bonding wire
7 Sealant

## Claims

1. A die bonding material for an optical semiconductor device, comprising
a first silicone resin containing a hydrogen atom bonded to a silicon atom,
a second silicone resin not containing a hydrogen atom bonded to a silicon atom, but containing an alkenyl group,
a catalyst for hydrosilylation reaction, and
at least one substance selected from the group consisting of anhydrous magnesium carbonate represented by chemical formula $MgCO_3$ not containing crystal water and coated body, said anhydrous magnesium represented by chemical formula $MgCO_3$, said coated body including the anhydrous magnesium carbonate and an organic resin, a silicone resin, or silica coated on the surface thereof.

2. The die bonding material for an optical semiconductor device according to claim 1,
wherein the first silicone resin is a first silicone resin which is represented by formula (1A) or formula (1B) shown below, and contains a hydrogen atom bonded to a silicon atom, and
the second silicone resin is a second silicone resin which is represented by formula (51A) or formula (51B) shown below, does not contain a hydrogen atom bonded to a silicon atom, but contains an alkenyl group;

**[Chem. 1]** $(R1R2R3SiO_{1/2})_a(R4R5SiO_{2/2})_b(R6SiO_{3/2})_c$ Formula (1A)

in the formula (1A), a, b, and c satisfy the following equations: a/ (a+b+c) = 0.05 to 0.50, b/ (a+b+c) = 0 to 0.40, and c/(a+b+c) = 0.30 to 0.80; and
at least one of R1 to R6 represents a hydrogen atom, and the rest of the R1 to R6 other than hydrogen atoms represent $C_1$ to $C_8$ hydrocarbon groups;

**[Chem. 2]** $(R1\ R2R3SiO_{1/2})_a(R4R5SiO_{2/2})_b(R6SiO_{3/2})_c(R7R8R9R10Si_2R11\ O_{2/2})_d$ **Formula (1B)**

in the formula (1B), a, b, c and d satisfy the following equations: a/(a+b+c+d) = 0.05 to 0. 50, b/(a+b+c+d) = 0 to 0.40, c/(a+b+c+d) = 0.30 to 0.80, and d/(a+b+c+d) = 0.01 to 0.40; and
at least one of R1 to R6 represents a hydrogen atom, the rest of the R1 to R6 other than hydrogen atoms represent $C_1$ to $C_8$ hydrocarbon groups, R7 to R10 each represent $C_1$ to $C_8$ hydrocarbon groups, and R11 represents a $C_1$ to $C_8$ bivalent hydrocarbon group;

**[Chem. 3]** $(R51R52R53SiO_{1/2})_p(R54R55SiO_{2/2})_q(R56SiO_{3/2})_r$ **Formula (51A)**

in the formula (51A), p, q, and r satisfy the following equations: p/(p+q+r) = 0.05 to 0.50, q/(p+q+r) = 0 to 0.40, and r/(p+q+r) = 0.30 to 0.80; and
at least one of R51 to R56 represents a phenyl group, at least one of R51 to R56 represents an alkenyl group, and the rest of the R51 to R56 other than phenyl groups and alkenyl groups represent $C_1$ to $C_8$ hydrocarbon groups;

**[Chem. 4]** $(R51R52R53SiO_{1/2})_p(R54R55SiO_{2/2})_q(R56SiO_{3/2})_r(R57R58R59R60Si_2R61O_{2/2})_s$ Formula (51B)

in the formula (51B) , p, q, r and s satisfy the following equations: p/(p+q+r+s) = 0.05 to 0.50, q/(p+q+r+s) = 0 to 0.40, r/(p+q+r+s) = 0.30 to 0.80, and s/(p+q+r+s) = 0.01 to 0.40; and
at least one of R51 to R56 represents a phenyl group, at least one of R51 to R56 represents an alkenyl group, the rest of the R51 to R56 other than phenyl groups and alkenyl groups represent $C_1$ to $C_8$ hydrocarbon groups, R57 to R60 each represent a $C_1$ to $C_8$ hydrocarbon group, and R61 represents a $C_1$ to $C_8$ bivalent hydrocarbon group.

3. The die bonding material for an optical semiconductor device according to claim 1 or claim 2,
wherein the first silicone resin is a first silicone resin containing a hydrogen atom bonded to a silicon atom, and an alkenyl group.

**4.** The die bonding material for an optical semiconductor device according to any one of claims 1 to 3, wherein the substance has an average particle diameter of not more than 3 μm.

**5.** The die bonding material for an optical semiconductor device according to any one of claims 1 to 4, further comprising a filler which is different from the substance and has an average particle diameter of 0.01 μm to 2 μm and a thermal conductivity of not less than 10 W/m·K.

**6.** The die bonding material for an optical semiconductor device according to claim 5, wherein the filler is at least one selected from the group consisting of aluminum oxide, boron nitride, silicon nitride, and zinc oxide.

**7.** An optical semiconductor device, comprising the die bonding material for an optical semiconductor device according to any one of claims 1 to 6, a member to be connected, and an optical semiconductor element connected to the member to be connected with the die bonding material for an optical semiconductor device.

[FIG. 1]

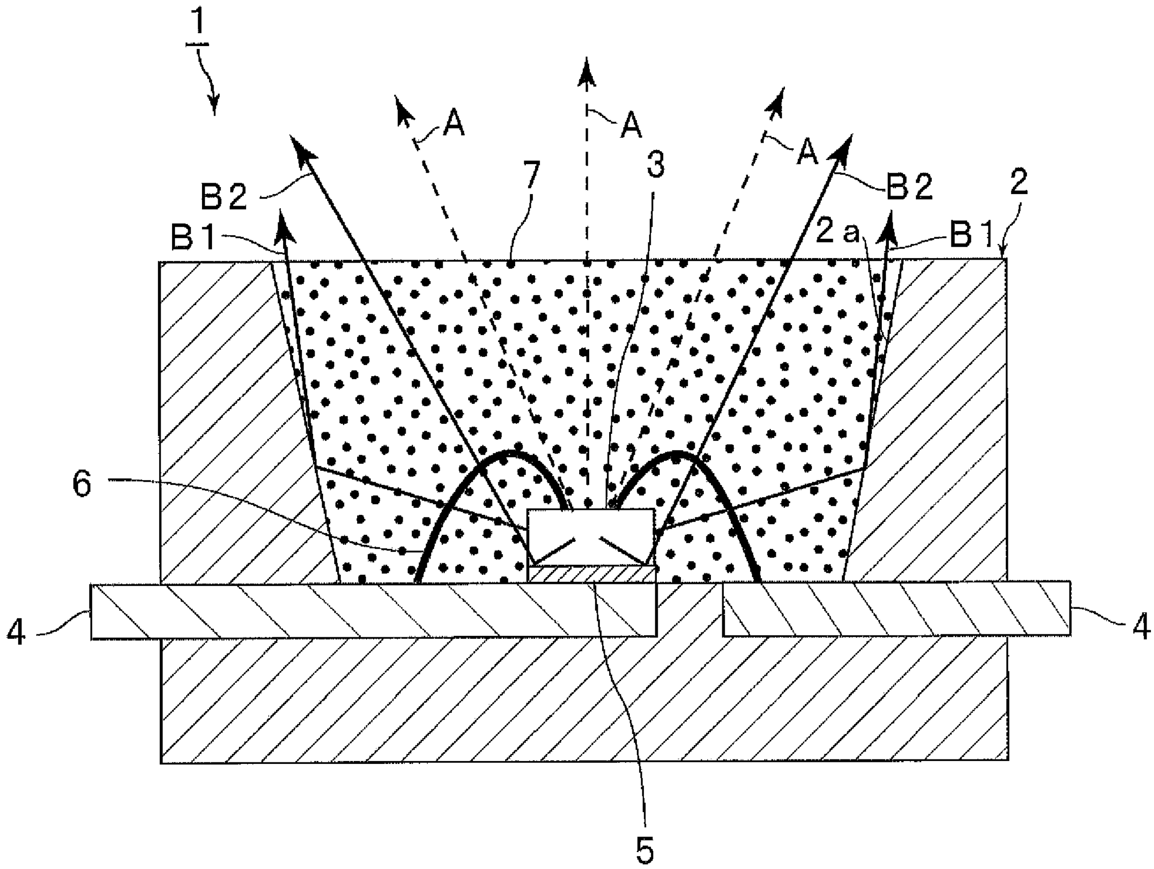

**INTERNATIONAL SEARCH REPORT**

International application No. PCT/JP2011/063023

A. CLASSIFICATION OF SUBJECT MATTER
*H01L33/48*(2010.01)i, *C08K3/26*(2006.01)i, *C08L83/05*(2006.01)i, *C08L83/07*(2006.01)i, *H01L21/52*(2006.01)i

According to International Patent Classification (IPC) or to both national classification and IPC

B. FIELDS SEARCHED

Minimum documentation searched (classification system followed by classification symbols)
H01L33/48, C08K3/26, C08L83/05, C08L83/07, H01L21/52

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| P,X | JP 2010-163478 A (Shin-Etsu Chemical Co., Ltd.), 29 July 2010 (29.07.2010), claim 1; paragraphs [0015], [0020] (Family: none) | 1 |
| Y | JP 2010-43221 A (Shin-Etsu Chemical Co., Ltd.), 25 February 2010 (25.02.2010), claim 1; paragraphs [0013], [0019] (Family: none) | 1,4-7 |
| Y | JP 2003-49150 A (Mitsubishi Pencil Co., Ltd.), 21 February 2003 (21.02.2003), paragraph [0004] (Family: none) | 1,4-7 |

☒ Further documents are listed in the continuation of Box C.    ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 June, 2011 (29.06.11) | 12 July, 2011 (12.07.11) |

| Name and mailing address of the ISA/ | Authorized officer |
|---|---|
| Japanese Patent Office | |
| Facsimile No. | Telephone No. |

Form PCT/ISA/210 (second sheet) (July 2009)

INTERNATIONAL SEARCH REPORT

International application No. PCT/JP2011/063023

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2004-217862 A (Hitachi Chemical Co., Ltd.), 05 August 2004 (05.08.2004), claim 6 (Family: none) | 5,6 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2009114365 A